# EUROPEAN PATENT APPLICATION

(11) **EP 4 503 093 A1**
(43) Date of publication of application: **05.02.2025**
(21) Application number: 23774338.0
(22) Date of filing: 17.02.2023
(51) Int. Cl.: H01L 21/304, C11D 7/06, C11D 7/26, C11D 7/32, C11D 7/36

(54) **COMPOSITION, AND PRODUCTION METHOD FOR SEMICONDUCTOR ELEMENT**

(30) Priority: 25.03.2022 JP 2022050467
(71) Applicant: FUJIFILM Corporation, Tokyo 106-8620 (JP)
(72) Inventor: MURO, Naotsugu, Haibara-gun, Shizuoka 421-0396 (JP); INABA, Tadashi, Haibara-gun, Shizuoka 421-0396 (JP); KAMIMURA, Tetsuya, Haibara-gun, Shizuoka 421-0396 (JP)
(74) Representative: HGF
(86) International application number: PCT/JP2023/005713
(87) International publication number: WO 2023/181739

(57) **Abstract**

An object of the present invention is to provide a composition in which, even in a case of being used after a lapse of a predetermined period from production, removal performance of residues and anticorrosion properties of a tungsten-containing film are excellent, and deterioration of electrical properties of the tungsten-containing film can be suppressed; and to provide a manufacturing method of a semiconductor element.

The composition of the present invention contains sorbic acid, citric acid, an amine-containing compound which is at least one selected from the group consisting of ammonia, an organic amine, a quaternary ammonium compound, and salts thereof, a specific compound which has at least one group selected from the group consisting of a phosphono group and a phosphoric acid group, and water, in which a pH at 25°C is 4.0 to 9.0.

## Description

### BACKGROUND OF THE INVENTION

### 1. Field of the Invention

The present invention relates to a composition and a manufacturing method of a semiconductor element.

### 2. Description of the Related Art

Semiconductor elements such as a charge-coupled device (CCD) and a memory are manufactured by forming a fine electronic circuit pattern on a substrate using a photolithographic technique. Specifically, the semiconductor elements are manufactured by forming a resist film on a laminate which has a metal film serving as a wiring line material, an etching stop layer, and an interlayer insulating layer on a substrate, and carrying out a photolithography step and a dry etching step (for example, a plasma etching treatment).

In the manufacture of the semiconductor element, a chemical mechanical polishing treatment in which a surface of a semiconductor substrate having a metal wiring line film, a barrier metal, an insulating film, or the like is flattened using a polishing liquid containing polishing fine particles (for example, silica and alumina) or the like may be carried out. In the chemical mechanical polishing treatment, residues of metal components derived from the polishing fine particles used in the chemical mechanical polishing treatment, a polished wiring line metal film, and/or a barrier metal, and the like are likely to remain on the surface of the semiconductor substrate after the chemical mechanical polishing treatment.

Since these residues can short-circuit wiring lines and adversely affect electrical characteristics of a semiconductor, a cleaning step in which these residues are removed from the surface of the semiconductor substrate is generally carried out.

For example, JP2009-531512A discloses a cleaning solution containing at least one cleaning agent including an organic acid compound, at least one preservative compound which substantially minimizes or prevents growth of a microorganism in the cleaning solution, and at least one amine compound.

### SUMMARY OF THE INVENTION

With the miniaturization of the semiconductor element, it is required for a composition used in a manufacturing process of the semiconductor element, such as a cleaning liquid for a semiconductor substrate, that removal performance of residues (for example, abrasive grains, metal-containing substances, organic substances, substrate materials, and mixtures thereof) is more excellent, damage to an object such as a substrate (for example, corrosion of a metal-containing film) is suppressed, and electrical properties of the metal-containing film formed as a wiring line or the like on the semiconductor substrate are suppressed.

On the other hand, the number of element species used in the manufacturing process of the semiconductor element tends to increase, so that, in order to handle new element species, there is a demand for a composition having a wide pH range including a strong acidity, a strong alkalinity, and a neutral pH which is an intermediate of the strong acidity and the strong alkalinity.

As a result of studying a composition for a semiconductor substrate in the vicinity of the neutral, according to the technical content disclosed in JP2009-531512A by the present inventors, it has been found that there is room for improvement in terms of simultaneously solving the three problems of the removal performance of residues, the anticorrosion properties, and the deterioration suppression of the electrical properties with respect to a metal-containing film (particularly, a tungsten-containing film) of the semiconductor substrate in a case where the composition is used after a predetermined period of time has elapsed from the production.

Therefore, an object of the present invention is to provide a composition in which, even in a case of being used after a lapse of a predetermined period from production, removal performance of residues and anticorrosion properties of a tungsten-containing film are excellent, and deterioration of electrical properties of the tungsten-containing film can be suppressed. Another object of the present invention is to provide a manufacturing method of a semiconductor element.

The present inventors have conducted intensive studies to achieve the above-described objects, and as a result, they have found that the above-described objects can be achieved by the following configurations.
[1] A composition comprising:
   sorbic acid;
   citric acid;
   an amine-containing compound which is at least one selected from the group consisting of ammonia, an organic amine, a quaternary ammonium compound, and salts thereof;
   a specific compound which has at least one group selected from the group consisting of a phosphono group and a phosphoric acid group; and
   water,
   in which a pH at 25°C is 4.0 to 9.0.
[2] The composition according to [1],
   in which a ratio of a content of the citric acid to a content of the sorbic acid is 1 to 50 in terms of mass ratio.
[3] The composition according to [1] or [2],
   in which a ratio of a content of the amine-containing compound to a content of the sorbic acid is 10 to 500 in terms of mass ratio.
[4] The composition according to any one of [1] to [3],
   in which the specific compound includes a compound having a phosphono group.
[5] The composition according to any one of [1] to [4],
   in which the specific compound includes a compound having at least two phosphono groups.
[6] The composition according to any one of [1] to [5],
   in which the amine-containing compound includes at least one selected from the group consisting of ammonia, an alkanolamine, a quaternary ammonium compound, and salts thereof.
[7] The composition according to any one of [1] to [6],
   in which the amine-containing compound includes an alkanolamine.
[8] The composition according to any one of [1] to [7],
   in which the composition contains substantially no abrasive grains.
[9] The composition according to any one of [1] to [8],
   in which an electrical conductivity at 25°C is 0.01 to 30 mS/cm.
[10] The composition according to any one of [1] to [9],
   in which a content of a phosphate ion is 20 mass ppm or less with respect to the composition.
[11] The composition according to any one of [1] to [10],
   in which the composition is used in a cleaning liquid for a semiconductor substrate which has been subjected to a chemical mechanical polishing treatment.
[12] The composition according to [11],
   in which the semiconductor substrate contains tungsten.
[13] The composition according to [11] or [12],
   in which a diluted liquid obtained by diluting the composition with water by 50 times or more is used as the cleaning liquid.
[14] A manufacturing method of a semiconductor element, comprising:
   a step of cleaning a semiconductor substrate using the composition according to any one of [1] to [12].
[15] A manufacturing method of a semiconductor element, comprising:
   a step of subjecting a semiconductor substrate to a chemical mechanical polishing treatment; and
   a step of cleaning the semiconductor substrate which has been subjected to the chemical mechanical polishing treatment using the composition according to any one of [1] to [12] or a diluted liquid obtained by diluting the composition with water.

According to the present invention, it is possible to provide a composition in which, even in a case of being used after a lapse of a predetermined period from production, removal performance of residues and anticorrosion properties of a tungsten-containing film are excellent, and deterioration of electrical properties of the tungsten-containing film can be suppressed. In addition, according to the present invention, it is possible to provide a manufacturing method of a semiconductor element.

### DESCRIPTION OF THE PREFERRED EMBODIMENTS

Hereinafter, an example of forms for carrying out the present invention will be described.

The present invention is not limited to the following embodiments, and can be variously modified within the scope of the gist.

In the present specification, numerical ranges represented by "to" include numerical values before and after "to" as lower limit values and upper limit values.

In the present specification, a term "preparation" means not only preparation by a treatment such as synthesis and blending of raw materials, but also procuring a predetermined substance by purchase or the like.

In the present specification, in a case where there are two or more components corresponding to a certain component, "content" of such a component means the total content of the two or more components, unless otherwise specified.

Unless otherwise specified, compounds described in the present specification may include structural isomers, optical isomers, and isotopes. In addition, one kind of structural isomer, optical isomer, and isotope may be included, or two or more kinds thereof may be included.

In the present specification, psi means pound-force per square inch; and 1 psi = 6894.76 Pa.

In the present specification, "ppm" means "parts-per-million (10⁻⁶)", and "ppb" means "parts-per-billion (10⁻⁹)".

In the present specification, 1 Å (angstrom) corresponds to 0.1 nm.

In the present specification, unless otherwise specified, a weight-average molecular weight (Mw) and a number-average molecular weight (Mn) are values converted using polystyrene as a standard substance, which are measured by a gel permeation chromatography (GPC) analyzer using TSKgel GMHxL, TSKgel G4000HxL, or TSKgel G2000HxL (all of which are manufactured by Tosoh Corporation) as a column, using tetrahydrofuran as an eluent, using a differential refractometer as a detector, and using polystyrene as a standard substance.

In the present specification, unless otherwise specified, a molecular weight of a compound having a molecular weight distribution is the weight-average molecular weight.

In the present specification, "total solid content" means the total content of all components contained in the composition, other than a solvent such as water and an organic solvent.

### [Composition]

The composition according to the embodiment of the present invention (hereinafter, also simply referred to as "composition") contains sorbic acid, a citric acid, an amine-containing compound which is at least one selected from the group consisting of ammonia, an organic amine, a quaternary ammonium compound, and salts thereof, a specific compound which has at least one group selected from the group consisting of a phosphono group and a phosphoric acid group, and water. In addition, a pH of the composition at 25°C is 4.0 to 9.0.

In the present specification, the sorbic acid, the citric acid, the above-described amine-containing compound, and the above-described specific compound are also referred to as "component A", "component B", "component C", and "component D", respectively.

The present inventors have found that, in a case where the composition contains the above-described components A to D and the pH of the composition is 4.0 to 9.0, three effects of removal performance of residues, anticorrosion properties of a tungsten-containing film, and suppression of deterioration of electrical properties of the tungsten-containing film are balanced and excellent, and have completed the present invention.

The detailed mechanism by which the effects of the present invention are obtained with such a composition is not clear, but the present inventors have presumed as follows.

In a case where a pH of a composition used in a manufacturing process of a semiconductor element is adjusted to a region of 4 to 9, it is presumed that, as time elapses, extremely fine floating matter in the air is dissolved or accumulated, which affects the original residue removability and anticorrosion properties of the composition; and extremely fine residues remain on a surface of the object to be treated after the treatment, which affects the electrical properties.

On the other hand, in the present composition, it is presumed that the influence of the above-described floating matter and the like, mixed in the composition, is suppressed by containing the above-described components A to D, and thus deterioration of the residue removability, the anticorrosion properties, and the electrical properties can be suppressed.

In the present specification, the fact that at least one of the removal performance of residues, the anticorrosion properties of a tungsten-containing film, or the suppression of deterioration of electrical properties of the tungsten-containing film is excellent is also referred to as "the effect of the present invention is excellent".

Hereinafter, each component contained in the composition will be described.

### [Component A (sorbic acid)]

The composition contains sorbic acid (hexadienoic acid).

The sorbic acid may be in a form of a salt. Examples of the above-described salt include known salts such as a sodium salt, a potassium salt, and an ammonium salt.

A content of the sorbic acid is not particularly limited, but from the viewpoint that the effect of the present invention is more excellent, it is preferably 0.0001% to 0.1% by mass, more preferably 0.001% to 0.08% by mass, and still more preferably 0.01% to 0.08% by mass with respect to the total mass of the composition.

In addition, the content of the sorbic acid is preferably 0.01% to 30.0% by mass and more preferably 0.05% to 12.0% by mass with respect to the total solid content in the composition.

### [Component B (citric acid)]

The composition contains citric acid.

The citric acid may be in a form of a salt. Examples of the above-described salt include known salts such as a sodium salt, a potassium salt, and an ammonium salt.

A content of the citric acid is preferably 0.001% to 1.0% by mass and more preferably 0.01% to 0.5% by mass with respect to the total mass of the composition.

The content of the citric acid is preferably 0.1% to 1.0% by mass and more preferably 0.3% to 0.6% by mass with respect to the total solid content in the composition.

From the viewpoint that the residue removability is more excellent, a ratio B/A of the content of the citric acid to the content of the sorbic acid (content B of citric acid/content B of sorbic acid) is preferably 1 to 50, more preferably 3 to 30, and still more preferably 4 to 10 in terms of mass ratio.

### [Component C (amine-containing compound)]

The composition contains, as the component C, an amine-containing compound which is at least one a selected from the group consisting of ammonia, an organic amine, and a quaternary ammonium compound, and salts thereof.

A compound included in the component D is not included in the component C.

The component C may be in a form of a salt. Examples of the above-described salt include a salt of an inorganic acid formed by a non-metal which is at least one selected from the group consisting of Cl, S, N, and P and is bonded to hydrogen; and a chloride, a sulfate, or a nitrate is preferable. In addition, the component C may form a salt with an acidic compound such as sorbic acid, citric acid, and an organic acid described later.

### <Ammonia>

The composition may contain ammonia as the component C. In the present specification, an ammonium cation (NH₄⁺) and a salt of the ammonium cation and a counter anion (for example, ammonium hydroxide (NH₄OH) or the like) correspond to the ammonia.

### <Organic amine>

The composition may contain an organic amine as the component C.

The organic amine is a compound having at least one amino group selected from the group consisting of a primary amino group, a secondary amino group, and a tertiary amino group in the molecule; or a salt thereof.

The organic amine may be chain-like (linear or branched) or cyclic. It is preferable that the organic amine does not include an aromatic ring. In addition, it is preferable that the organic amine does not have a carboxy group.

Examples of the organic amine include an alkanolamine, an alicyclic amine, and an aliphatic amine other than the alkanolamine and the alicyclic amine.

Among the organic amines, the alkanolamine is a compound further having at least one hydroxyalkyl group in the molecule. The alkanolamine may have any of a primary amino group, a secondary amino group, or a tertiary amino group, but preferably has a primary amino group.

The number of amino groups included in the alkanolamine is, for example, 1 to 5, preferably 1 to 3. The number of hydroxy groups included in the alkanolamine is, for example, 1 to 5, and more preferably 1 to 3.

Among these, the alkanolamine more preferably has only a primary amino group as the amino group.

Examples of the alkanolamine include monoethanolamine (MEA), 3-amino-1-propanol, 1-amino-2-propanol, trishydroxymethylaminomethane (Tris), 2-amino-2-methyl-1-propanol (AMP), 2-dimethylamino-2-methyl-1-propanol (DMAMP), 2-amino-2-methyl-1,3-propanediol (AMPDO), 2-amino-2-ethyl-1,3-propanediol (AEPDO), 2-amino-1,3-propanediol (2-APDO), 3-amino-1,2-propanediol (3-APDO), 3-methylamino-1,2-propanediol (MAPDO), 2-(methylamino)-2-methyl-1-propanediol (N-MAMP), 2-(aminoethoxy)ethanol (AEE), 2-(2-aminoethylamino)ethanol (AAE), diethanolamine (DEA), triethanolamine (TEA), N-methylethanolamine, N-butylethanolamine, N-cyclohexylethanolamine, 2-(ethylamino)ethanol, propylaminoethanol, diethylene glycol amine (DEGA), N,N'-bis(2-hydroxyethyl)ethylenediamine, 1,2-bis(2-aminoethoxy)ethane, N-tert-butyldiethanolamine, N-butyldiethanolamine, N-methyldiethanolamine, 1-piperidineethanol, and 1-(2-hydroxyethyl)piperazine.

Among these, MEA, Tris, DMAMP, AMP, AMPDO, AEPDO, 2-APDO, 3-APDO, or MAPDO is preferable, and MEA or Tris is more preferable.

Examples of the alicyclic amine include a cyclic amidine compound and a piperazine compound. A compound included in the alkanolamine is not included in the alicyclic amine.

The cyclic amidine compound is a compound having a heterocyclic ring including an amidine structure (>N-C=N-) in the ring. The number of ring members in the above-described heterocyclic ring included in the cyclic amidine compound is preferably 5 or 6 and more preferably 6.

Examples of the cyclic amidine compound include diazabicycloundecene (1,8-diazabicyclo[5.4.0]undec-7-ene: DBU), diazabicyclononene (1,5-diazabicyclo[4.3.0]non-5-ene: DBN), 3,4,6,7,8,9,10, 11-octahydro-2H-pyrimid[1.2-a]azocine, 3,4,6,7,8,9-hexahydro-2H-pyrido[1.2-a]pyrimidine, 2,5,6,7-tetrahydro-3H-pyrrolo[1.2-a]imidazole, 3-ethyl-2,3,4,6,7,8,9,10-octahydropyrimid[1.2-a]azepine, and creatinine.

The piperazine compound is a compound having a hetero-6-membered ring (a piperazine ring) in which an opposite >CH- group of a cyclohexane ring is replaced with a tertiary amino group (>N-).

Examples of the piperazine compound include piperazine, 1-methylpiperazine, 2-methylpiperazine, 1-ethylpiperazine, 1-propylpiperazine, 1-butylpiperazine, 1,4-dimethylpiperazine, 2,5-dimethylpiperazine, 2,6-dimethylpiperazine, 1-phenylpiperazine, N-(2-aminoethyl)piperazine (AEP), 1,4-bis(2-aminoethyl)piperazine (BAEP), 1,4-bis(3-aminopropyl)piperazine (BAPP), and 1,4-diazabicyclo[2.2.2]octane (DABCO).

Examples of the alicyclic amine other than the piperazine compound and the cyclic amidine compound include a compound having a nitrogen-containing 5-membered ring or a nitrogen-containing 7-membered ring, such as 1,3-dimethyl-2-imidazolidinone.

Examples of the aliphatic amine other than the alkanolamine and the alicyclic amine include a primary aliphatic amine (aliphatic amine having a primary amino group), a secondary aliphatic amine (aliphatic amine having a secondary amino group), a tertiary aliphatic amine (aliphatic amine having a tertiary amino group), and salts thereof.

Examples of the primary aliphatic amine include methylamine, ethylamine, propylamine, dimethylamine, diethylamine, n-butylamine, 3-methoxypropylamine, tert-butylamine, n-hexylamine, n-octylamine, and 2-ethylhexylamine.

Examples of the secondary aliphatic amine include alkylenediamines such as ethylenediamine (EDA), 1,3-propanediamine (PDA), 1,2-propanediamine, 1,3-butanediamine, and 1,4-butanediamine, and polyalkylpolyamines such as diethylenetriamine (DETA), triethylenetetramine (TETA), bis(aminopropyl)ethylenediamine (BAPEDA), and tetraethylenepentamine.

Examples of the tertiary aliphatic amine include tertiary alkyl amines such as trimethylamine and triethylamine; alkylene amines such as 1,3-bis(dimethylamino)butane; and polyalkylpolyamines such as N,N,N',N",N"-pentamethyldiethylenetriamine.

As the organic amine, an alkanolamine is preferable, and the above-described preferred aspect of the alkanolamine is more preferable.

### <Quaternary ammonium compound>

The composition may contain, as the component C, a quaternary ammonium compound which is a compound having at least one quaternary ammonium cationic group in the molecule or a salt thereof.

The quaternary ammonium compound is not particularly limited as long as it is a compound having at least one quaternary ammonium cationic group formed by substituting four hydrocarbon groups (preferably, alkyl groups) to a nitrogen atom, or a salt thereof.

Examples of the quaternary ammonium compound include a quaternary ammonium hydroxide, a quaternary ammonium fluoride, a quaternary ammonium bromide, a quaternary ammonium iodide, a quaternary ammonium acetate, and a quaternary ammonium carbonate.

The quaternary ammonium compound is preferably a quaternary ammonium hydroxide, and more preferably a compound represented by Formula (a1).

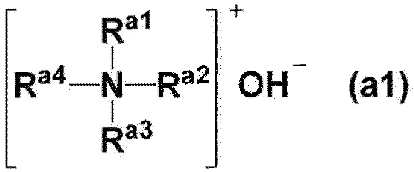

In Formula (a1), R^{a1} to R^{a4} each independently represent an alkyl group having 1 to 16 carbon atoms, an aryl group having 6 to 16 carbon atoms, an aralkyl group having 7 to 16 carbon atoms, or a hydroxyalkyl group having 1 to 16 carbon atoms. At least two of R^{a1} to R^{a4} may be bonded to each other to form a cyclic structure.

From the viewpoint of availability, the compound represented by Formula (a1) is preferably a compound selected from the group consisting of tetramethylammonium hydroxide (TMAH), tetraethylammonium hydroxide (TEAH), tetrapropylammonium hydroxide, tetrabutylammonium hydroxide (TBAH), methyltripropylammonium hydroxide, methyltributylammonium hydroxide, ethyltrimethylammonium hydroxide, dimethyldiethylammonium hydroxide, benzyltrimethylammonium hydroxide (BzTMAH), hexadecyltrimethylammonium hydroxide, (2-hydroxyethyl)trimethylammonium hydroxide, and spiro-(1,1')-bipyrrolidinium hydroxide; and more preferably TMAH, TEAH, or TBAH.

As the component C, a compound selected from the group consisting of ammonia, an alkanolamine, a quaternary ammonium hydroxide, and salts thereof is preferable.

Among these, from the viewpoint of further suppressing the deterioration of electrical properties of the wiring line, a compound selected from the group consisting of an alkanolamine, a quaternary ammonium hydroxide, and salts thereof is more preferable.

In addition, from the viewpoint of further improving the anticorrosion properties of the metal-containing film, a compound selected from the group consisting of ammonia, an alkanolamine, and salts thereof is more preferable.

As the component C, an alkanolamine or a salt thereof is more preferable, and Tris is particularly preferable.

The component C may be used alone or in combination of two or more kinds thereof.

A content of the component C is preferably 0.01% to 20% by mass and more preferably 0.1% to 10% by mass with respect to the total mass of the composition.

The content of the component C is preferably 10% to 90% by mass and more preferably 30% to 70% by mass with respect to the total solid content in the composition.

From the viewpoint that the anticorrosion properties are more excellent, a ratio C/A of the content of the component C to the content of the sorbic acid (content C of component C/content A of sorbic acid) is preferably 10 to 500, more preferably 30 to 300, and still more preferably 100 to 150 in terms of mass ratio.

In addition, from the viewpoint that the residue removability is more excellent, a ratio B/C of the content of the citric acid to the content of the component C (content B of citric acid/content C of component C) is preferably 0.01 to 0.3, more preferably 0.03 to 0.2, and still more preferably 0.04 to 0.1 in terms of mass ratio.

### [Component D]

The composition contains, as the component D, a compound which has at least one group (hereinafter, also referred to as "specific group") selected from the group consisting of a phosphono group (-PO₃H₂) and a phosphoric acid group (-PO₄H₂).

The phosphono group and the phosphoric acid group included in the component D may form a salt with a counter ion or with other groups in the molecule.

The number of the specific groups included in the component D is not particularly limited, but is, for example, an integer of 1 to 6, preferably an integer of 2 to 5 and more preferably 2 or 3.

The number of carbon atoms in the component D is preferably 15 or less, more preferably 12 or less, and still more preferably 8 or less. The lower limit thereof is not particularly limited, but is preferably 2 or more.

Examples of the component D include a phosphono compound having a phosphono group as the specific group, and a phosphoric acid compound having a phosphoric acid group as the specific group.

The phosphono compound has at least one phosphono group in the molecule. From the viewpoint that the effect of the present invention is more excellent, the number of phosphono groups included in the phosphono compound is preferably 2 or more. The upper limit thereof is not particularly limited, and is, for example, an integer of 6 or less, preferably an integer of 5 or less and more preferably an integer of 4 or less.

A range of the number of carbon atoms in the phosphono compound is as described above.

Examples of the phosphono compound include 2-phosphonobutane-1,2,4-tricarboxylic acid (PBTCA), 4-phosphonobutyric acid, glycine-N,N-bis(methylenephosphonic acid), ethylidene diphosphonic acid, 1-hydroxyethylidene-1,1'-diphosphonic acid (HEDPO), 1-hydroxypropyridene-1,1'-diphosphonic acid, and 1-hydroxybutylidene-1,1'-diphosphonic acid, ethylaminobis(methylenephosphonic acid), dodecylaminobis(methylenephosphonic acid), nitrilotris(methylenephosphonic acid) (NTPO), ethylenediaminebis(methylenephosphonic acid) (EDDPO), 1,3-propylenediaminebis(methylenephosphonic acid), ethylenediaminetetra(methylenephosphonic acid) (EDTPO), ethylenediaminetetra(ethylenephosphonic acid), 1,3-propylenediaminetetra(methylenephosphonic acid) (PDTMP), 1,2-diaminopropanetetra(methylenephosphonic acid), 1,6-hexamethylenediaminetetra(methylenephosphonic acid), diethylenetriaminepenta(methylenephosphonic acid) (DEPPO), diethylenetriaminepenta(ethylenephosphonic acid), triethylenetetraminehexa(methylenephosphonic acid), and triethylenetetraminehexa(ethylenephosphonic acid).

As the phosphono compound, HEDPO, NTPO, or EDTPO is preferable, and HEDPO is more preferable.

The phosphoric acid compound is not particularly limited as long as it is a compound having at least one phosphoric acid group in the molecule, and examples thereof include condensed phosphoric acids and salts thereof, and organic compounds having a phosphoric acid group (phosphoric acid ester group).

Specific examples of the phosphoric acid compound include pyrophosphoric acid, metaphosphoric acid, triphosphoric acid, hexamethylenephosphoric acid, phytic acid, and salts thereof.

As the component D, from the viewpoint that the effect of the present invention is more excellent, a compound having a phosphono group is preferable, a compound having at least two phosphono groups is more preferable, a compound having two to four phosphono groups is still more preferable, and HEDPO or NTPO is particularly preferable.

The component D may be used alone or in combination of two or more kinds thereof.

A content of the component D is preferably 0.01% to 20% by mass and more preferably 0.1% to 10% by mass with respect to the total mass of the composition.

The content of the component D is preferably 10% to 90% by mass and more preferably 20% to 50% by mass with respect to the total solid content in the composition.

### [Water]

The composition contains water.

The type of water is not particularly limited as long as it does not have influence on the semiconductor substrate, and distilled water, deionized water, and pure water (ultrapure water) can be used. Pure water is preferable from the viewpoint that it contains almost no impurities and has less influence on the semiconductor substrate in a manufacturing step of the semiconductor substrate.

A content of the water in the composition is not particularly limited, and may be the remainder of the components A to D, and an optional component (described later) to be added as necessary.

The content of the water is, for example, 60% by mass or more, preferably 70% by mass or more and more preferably 80% by mass or more with respect to the total mass of the composition.

The upper limit thereof is not particularly limited, but may be, for example, 99.9% by mass or less, preferably 99% by mass or less with respect to the total mass of the composition.

### [Optional component]

The composition may contain an optional component in addition to the components A to D and water described above. Examples of the optional component include an anticorrosion agent, a surfactant, a chelating agent, a pH adjusting agent, and various additives.

Hereinafter, the optional component will be described.

### <Anticorrosion agent>

The composition may contain an anticorrosion agent.

The anticorrosion agent is a compound having a function of preventing an exposure surface of a metal film included in the semiconductor substrate (particularly, a metal film containing tungsten) from being corroded; and examples thereof include a water-soluble polymer.

In addition, the above-described component C may also serve as the anticorrosion agent.

The water-soluble polymer is a water-soluble compound having a weight-average molecular weight of 1,000 or more. In the present specification, the "water-soluble" means that a mass of a compound dissolved in 100 g of water at 20°C is 0.1 g or more. The water-soluble polymer does not include an organic acid and a compound which functions as an anionic surfactant, which will be described later.

Examples of the water-soluble polymer include polyvinyl alcohol, hydroxyethyl cellulose, polyvinylpyrrolidone, poly(meth)acrylic acid, poly(meth)acrylamide, and polystyrene sulfonic acid.

The weight-average molecular weight of the water-soluble polymer is preferably 1,000 to 100,000, more preferably 2,000 to 50,000, and still more preferably 5,000 to 50,000.

The composition may contain other anticorrosion agents in addition to the above-described components.

Examples of the other anticorrosion agents include an ascorbic acid compound, a catechol compound, a hydrazide compound, a reducing sulfur compound, sugars (fructose, glucose, ribose, and the like), polyols (ethylene glycol, propylene glycol, glycerin, and the like), polyvinylpyrrolidone, phenanthroline, flavonol and a derivative thereof, and anthocyanin and a derivative thereof.

The anticorrosion agent may be used alone or in combination of two or more kinds thereof.

In a case where the composition contains an anticorrosion agent, a content of the anticorrosion agent is preferably 0.0001% to 10% by mass and more preferably 0.001% to 3% by mass with respect to the total mass of the composition.

In a case where the composition contains an anticorrosion agent, a content of the anticorrosion agent is preferably 0.001% to 30% by mass and more preferably 0.01% to 10% by mass with respect to the total solid content in the composition.

As these anticorrosion agents, commercially available ones may be used, or those synthesized according to a known method may be used.

### <Surfactant>

The composition may include a surfactant.

The surfactant is a compound having a hydrophilic group and a hydrophobic group (lipophilic group) in one molecule. Examples of the surfactant include a nonionic surfactant, an anionic surfactant, a cationic surfactant, and an amphoteric surfactant.

From the viewpoint that the anticorrosion performance of the metal film and the removability of residues such as abrasive grains are more excellent, the composition preferably contains the surfactant.

In a large number of cases, the surfactant has at least one hydrophobic group selected from the group consisting of an aliphatic hydrocarbon group, an aromatic hydrocarbon group, and a group obtained by combining these groups.

In a case where the hydrophobic group includes an aromatic hydrocarbon group, the number of carbon atoms in the hydrophobic group included in the surfactant is preferably 6 or more and more preferably 10 or more. In a case where the hydrophobic group does not include an aromatic hydrocarbon group and consists of only aliphatic hydrocarbon group, the number of carbon atoms in the hydrophobic group included in the surfactant is preferably 9 or more, more preferably 13 or more, and still more preferably 16 or more. The upper limit of the number of carbon atoms in the hydrophobic group is preferably 20 or less and more preferably 18 or less.

The number of carbon atoms in the surfactant is preferably 16 to 100.

Examples of the nonionic surfactant include an ester-type nonionic surfactant, an ether-type nonionic surfactant, an ester-ether-type nonionic surfactant, and an alkanolamine-type nonionic surfactant, and an ether-type nonionic surfactant is preferable.

Examples of the nonionic surfactant include polyethylene glycol, alkyl polyglucoside (Triton BG-10 and Triton CG-110 surfactant manufactured by Dow Chemical Company), octylphenol ethoxylate (Triton X-114 manufactured by Dow Chemical Company), silane polyalkylene oxide (copolymer) (Y-17112-SGS sample manufactured by Momentive Performance Materials), nonylphenol ethoxylate (Tergitol NP-12 and Triton (registered trademark) X-102, X-100, X-45, X-15, BG-10, and CG-119 manufactured by Dow Chemical Company), Silwet (registered trademark) HS-312 (manufactured by Momentive Performance Materials), tristyrylphenol ethoxylate (MAKON TSP-20 manufactured by Stepan), polyoxyethylene alkyl ether, polyoxyethylene alkylphenyl ether, alkylallylformaldehyde-condensed polyoxyethylene ether, polyoxyethylene polyoxypropylene block polymer, polyoxyethylene polyoxypropylene alkyl ether, polyoxyethylene ethers of glycerin ester, polyoxyethylene ether of sobitan ester, polyoxyethylene ether of sorbitol ester, polyethylene glycol fatty acid ester, glycerin ester, polyglycerin ester, sorbitan ester, propylene glycol ester, sucrose ester, fatty acid alkanolamide, polyoxyethylene fatty acid amide, polyoxyethylene alkylamide, alcohol ethoxylates such as BRIJ (registered trademark) 56 (C₁₆H₃₃(OCH₂CH₂)₁₀OH), BRIJ (registered trademark) 58 (C₁₆H₃₃(OCH₂CH₂)₂₀OH), and BRIJ (registered trademark) 35 (C₁₂H₂₅(OCH₂CH₂)₂₃OH), alcohol (primary and secondary alcohol) ethoxylates, amine ethoxylate, glucoside, glucamide, poly(ethylene glycol-co-propylene glycol), cetyl alcohol, stearyl alcohol, cetostearyl alcohol (cetyl and stearyl alcohol), oleyl alcohol, octaethylene glycol monododecyl ether, pentaethylene glycol monododecyl ether, polyoxypropylene glycol alkyl ether, decyl glucoside, lauryl glucoside, octyl glucoside, polyoxyethylene glycol octylphenol ether, nonoxynol-9, glycerol alkyl ester, glyceryl laurate, polyoxyethylene glycol sorbitan alkyl ester, polysorbate, sorbitan alkyl ester, spun, cocamide MEA, cocamide DEA, dodecyldimethylamine oxide, block copolymer of polypropylene glycol, and mixtures thereof.

Examples of the anionic surfactant include a phosphonic acid-based surfactant having a phosphono group as a hydrophilic group (acid group), a sulfonic acid-based surfactant having a sulfo group as a hydrophilic group (acid group), a carboxylic acid-based surfactant having a carboxy group as a hydrophilic group (acid group), and a sulfate ester-based surfactant having a sulfuric acid ester group as a hydrophilic group (acid group).

Examples of the anionic surfactant include alkylbenzenesulfonic acids such as dodecylbenzenesulfonic acid and ammonium dodecylbenzene sulfonate and salts thereof, alkylnaphthalene sulfonic acids such as propylnaphthalene sulfonic acid and triisopropylnaphthalene sulfonic acid and salts thereof, alkylphenyl ether disulfonic acids such as dodecylphenyl ether disulfonic acid and an alkyldiphenyl ether sulfonic acid and salts thereof; alkyldiphenyl ether disulfonic acids such as dodecyldiphenyl ether disulfonic acid and ammonium dodecyldiphenyl ether sulfonate and salts thereof; phenol sulfonic acid-formalin condensates and salts thereof, arylphenol sulfonic acid-formalin condensates and salts thereof; carboxylates such as decanecarboxylic acid, an N-acylamino acid salt and a polyoxyethylene or polyoxypropylene alkyl ether carboxylate; acylated peptides; sulfonates; sulfate esters such as a sulfated oil, an alkyl sulfate, an alkyl ether sulfate, sulfate ester salts such as a polyoxyethylene or polyoxypropylene alkylallyl ether sulfate and an alkylamide sulfate; phosphate ester salts; alkyl phosphates; polyoxyethylene or polyoxypropylene alkylallyl ether phosphates; ammonium lauryl sulfate; sodium lauryl sulfate (sodium dodecyl sulfate); sodium lauryl ether sulfate (SLES); sodium myreth sulfate; sodium dioctyl sulfosuccinate; octane sulfonate; perfluorooctanesulfonate (PFOS); perfluorobutane sulfonate; alkylbenzene sulfonates; alkylaryl ether phosphates; alkyl ether phosphates; alkyl carboxylates; fatty acid salts (soap); sodium stearate; sodium lauroyl sarcosinate; perfluorononanoate; perfluorooctanoate; and mixtures thereof.

Examples of the amphoteric surfactant include a carboxybetaine-type amphoteric surfactant, a sulfobetaine-type amphoteric surfactant, an aminocarboxylate, an imidazolinium betaine, lecithin, an alkylamine oxide, and mixtures thereof.

Examples of the surfactant also include compounds described in paragraphs [0092] to [0096] of JP2015-158662A, paragraphs [0045] and [0046] of JP2012-151273A, and paragraphs [0014] to [0020] of JP2009-147389A, the content of which is incorporated herein by reference.

The surfactant may be used alone or in combination of two or more kinds thereof.

In a case where the composition contains a surfactant, a content of the surfactant is preferably 0.001% to 8.0% by mass and more preferably 0.005% to 5.0% by mass with respect to the total mass of the composition.

In a case where the composition contains a surfactant, a content of the surfactant is preferably 0.01% to 50.0% by mass and more preferably 0.1% to 45.0% by mass with respect to the total solid content in the composition.

### <Chelating agent>

The composition may contain a chelating agent.

The chelating agent is a compound having a function of chelating with a metal included in residues in the semiconductor substrate, such as abrasive particles. Among these, a compound which has two or more functional groups (coordinating groups) forming a coordinate bond with a metal ion in one molecule is preferable.

The citric acid and the compound included in any of the above-described component C, the above-described component D, or the surfactant described later are not included in the chelating agent.

Examples of the coordinating group included in the chelating agent include an acid group. Examples of the acid group include a carboxy group, a sulfo group, and a phenolic hydroxyl group.

The number of carbon atoms in the chelating agent is preferably 15 or less, more preferably 12 or less, and still more preferably 8 or less. The upper limit thereof is not particularly limited, and is preferably 2 or more.

The chelating agent may be used alone or in combination of two or more kinds thereof.

### <pH adjusting agent>

The composition may contain a pH adjusting agent for adjusting and maintaining the pH of the composition. The composition may be adjusted to a pH range described later with the pH adjusting agent.

Examples of the pH adjusting agent include a basic compound and an acidic compound, other than the components described above.

Examples of the basic compound include a basic inorganic compound.

Examples of the basic inorganic compound include an alkali metal hydroxide and an alkaline earth metal hydroxide. The above-described component C and the above-described anticorrosion agent are not included in the basic inorganic compound.

Examples of the alkali metal hydroxide include lithium hydroxide, sodium hydroxide, potassium hydroxide, and cesium hydroxide. Examples of the alkaline earth metal hydroxide include calcium hydroxide, strontium hydroxide, and barium hydroxide.

The composition may contain, as the basic compound, at least one selected from the group consisting of hydrazides such as nitro, nitroso, oxime, ketoxime, aldoxime, nitron, lactam, isocyanide, and carbohydrazide, and urea, in addition to the above-described compounds.

In addition, the component C and the anticorrosion agent contained in the composition may function as the basic compound for adjusting the pH of the composition.

Examples of the acidic compound include inorganic acids and organic acids.

Examples of the inorganic acid include hydrochloric acid, sulfuric acid, sulfurous acid, nitric acid, nitrite, phosphoric acid, boric acid, and hexafluorophosphoric acid.

As the inorganic acid, hydrochloric acid or sulfuric acid is preferable.

The organic acid is an organic compound which has an acidic functional group and is acidic (with a pH of less than 7.0) in an aqueous solution. In the present specification, the sorbic acid, the citric acid, the component D, the above-described anionic surfactant, and the above-described chelating agent are not included in the organic acid.

Examples of the acidic functional group included in the organic acid include a carboxy group and a sulfo group. Examples of the organic acid include a carboxylic acid having at least one carboxy group and a sulfonic acid having at least one sulfo group.

Examples of the carboxylic acid include aliphatic monocarboxylic acids having a low carbon number (1 to 4 carbon atoms), such as formic acid, acetic acid, propionic acid, and butyric acid.

Examples of the sulfonic acid include aliphatic monosulfonic acids having a low carbon number (1 to 4 carbon atoms), such as methanesulfonic acid, ethanesulfonic acid, propanesulfonic acid, butanesulfonic acid, 2-hydroxyethanesulfonic acid, and 3-hydroxypropanesulfonic acid.

In addition, the acidic component contained in the composition may function as the acidic compound for adjusting the pH of the composition.

The pH adjusting agent may be used alone or in combination of two or more kinds thereof.

In a case where the composition contains a pH adjusting agent, a content thereof is selected depending on the type and amount of other components and the pH of the composition to be obtained, but it is preferably 0.03% to 10% by mass and more preferably 0.1% to 5% by mass with respect to the total mass of the composition.

### <Additive>

The composition may contain other components as an additive.

Examples of the other components include an oxidant, a fluorine compound, and an organic solvent.

Examples of the oxidant include a peroxide, a persulfide (for example, a monopersulfide or a dipersulfide), a percarbonate, an acid thereof, salts thereof.

Examples of the oxidant include an oxidative halide (a periodic acid such as iodic acid, metaperiodic acid, and orthoperiodic acid, and salts thereof), a perboric acid, a perboric acid salt, a cerium compound, and a ferricyanide (potassium ferricyanide or the like).

In a case where the composition contains an oxidant, a content of the oxidant is preferably 0.01% to 10.0% by mass and more preferably 0.05% to 5.0% by mass with respect to the total mass of the composition.

In a case where the composition contains an oxidant, a content of the oxidant is preferably 0.1% to 50.0% by mass and more preferably 1.0% to 30.0% by mass with respect to the total solid content in the composition.

Examples of the fluorine compound include compounds described in paragraphs [0013] to [0015] of JP2005-150236A, the content of which is incorporated herein by reference.

As the organic solvent, a known organic solvent can be used, and examples thereof include a hydrophilic organic solvent such as alcohol and ketone. The organic solvent may be used alone or in combination of two or more kinds thereof.

Used amounts of the fluorine compound and the organic solvent may be appropriately set within a range that does not impair the effects of the present invention.

The content of each of the components described above in the composition can be measured by a known method such as a gas chromatography-mass spectrometry (GC-MS) method, a liquid chromatography-mass spectrometry (LC-MS) method, and an ion-exchange chromatography (IC) method.

### [Physical properties of composition]

### <pH>

The pH of the composition according to the embodiment of the present invention at 25°C is 4.0 to 9.0.

The pH of the composition is preferably 5.0 to 7.0 and more preferably 5.5 to 6.5.

The pH of the composition can be measured by a method in accordance with JIS Z 8802-1984, using a known pH meter (for example, "WM-32EP" manufactured by DKK-TOA CORPORATION, or the like). A temperature for measuring the pH is 25°C.

The pH of the composition can be adjusted by the content of the components having a function as a pH adjusting agent, such as the sorbic acid, the citric acid, the component C, the component D, the anticorrosion agent, the surfactant, and the chelating agent, and the content of the above-described pH adjusting agent.

### <Electrical conductivity>

An electrical conductivity of the composition is not particularly limited, but is preferably 0.01 to 30 mS/cm, more preferably 0.1 to 20 mS/cm, and still more preferably 5 to 17 mS/cm.

The electrical conductivity of the composition is an electrical conductivity (mS/cm) at 25°C, which is measured using an electrical conductivity meter (for example, "WM-32EP" manufactured by DKK-TOA CORPORATION, or the like).

The electrical conductivity of the composition can be adjusted by the content of the components which can be ionized in the composition, such as the sorbic acid, the citric acid, and the component C described above.

### <Metal content>

In the composition, a content (measured as an ion concentration) of each metal contained in the solution as an impurity (metal element of Fe, Co, Na, Cu, Mg, Mn, Li, Al, Cr, Ni, Zn, Sn, and Ag) is preferably 5 mass ppm or less and more preferably 1 mass ppm or less with respect to the total mass of the cleaning composition. It is assumed that, in manufacturing of a cutting-edge semiconductor element, a composition having even higher purity is required, and thus the metal content thereof is more preferably a value lower than 1 mass ppm, that is, lower than a value of mass ppb order, particularly preferably 100 mass ppb or less, and most preferably less than 10 mass ppb. The lower limit thereof is preferably 0.

Examples of a method for reducing the metal content include performing a purifying treatment such as distillation and filtration using an ion exchange resin or a filter at a stage of raw materials used in the production of the composition or a stage after the production of the composition.

Examples of other methods for reducing the metal content include using a container with less elution of impurities, which will be described later, as a container that accommodates the raw material or the produced composition. In addition, other examples thereof include lining an interior wall of the pipe with a fluororesin to prevent the elution of metal components from a pipe or the like during the production of the composition.

### <Content of phosphate ion>

In the composition, from the viewpoint of triangular position of the residue removability, the anticorrosion properties, and the wiring electrical properties, a content of a phosphate ion is preferably 200 mass ppm or less, more preferably 50 mass ppm or less, and still more preferably 20 mass ppm or less with respect to the total mass of the composition. The lower limit thereof may be 0 mass ppm, more preferably 0.1 mass ppm or more with respect to the total mass of the composition.

The above-described content of the phosphate ion means the total content of a dihydrogen phosphate ion (H₂PO₄⁻), a hydrogen phosphate ion (HPO₄²⁻), a phosphate ion (PO₄³⁻), a hypophosphite ion (H₂PO₃⁻), and a phosphite ion (HPO₃²⁻).

Examples of a method for reducing the metal content include performing a purifying treatment such as distillation and filtration using an ion exchange resin at a stage of raw materials used in the production of the composition or a stage after the production of the composition.

### <Coarse particles>

The composition may contain coarse particles, but it is preferable that a content thereof is preferably low.

The coarse particles mean particles having a diameter (particle size) of 0.1 µm or more, in a case where a shape of the particles is regarded as a sphere.

The content of the coarse particles in the composition, in terms of content of particles having a particle size of 0.1 µm or more, is preferably 10,000 or less and more preferably 5,000 or less per 1 mL of the composition. The lower limit thereof is preferably 0 or more and more preferably 0.01 or more per 1 mL of the composition.

The coarse particles contained in the cleaning composition correspond to, for example, particles such as rubbish, dust, organic solid, and inorganic solid, which are contained as impurities in raw materials, and particles such as rubbish, dust, organic solid, and inorganic solid, which are brought in as contaminants during the preparation of the composition, in which those particles are finally present as particles without being dissolved in the composition.

The content of the coarse particles present in the composition can be measured in a liquid phase by using a commercially available measuring device in a light scattering type liquid particle measuring method using a laser as a light source.

Examples of a method for removing the coarse particles include a purification treatment such as filtering, which will be described later.

It is preferable that the composition contains substantially no abrasive grains, depending on the use thereof.

The abrasive grains are fine particles made of a material such as silica and alumina, which are contained in a polishing liquid used in a chemical mechanical polishing treatment described later.

In the present specification, examples of the abrasive grains include particles having a diameter (particle size) of 10 nm or more, in a case where a shape of the abrasive grains is regarded as a sphere, and the composition substantially containing no abrasive grains means that a content of the abrasive grains having a particle size of 10 nm or more contained in the composition is 1% by mass or less per composition.

The measurement of the content of the abrasive grains present in the composition and the removal of the abrasive grains can be performed according to the method for measuring the content of the coarse particles and the method for removing the coarse particles, respectively.

### [Production of composition]

The composition can be produced by a known method. Hereinafter, a production method of the composition will be described in detail.

### <Preparing step>

The composition can be produced, for example, by mixing the respective components described above.

The order and/or timing of mixing the respective components described above are not particularly limited, and examples thereof include a method in which the components A to D and the optional component are sequentially charged into a container filled with purified pure water and mixed with stirring. In particular, from the viewpoint of ease of preparing a composition having a desired composition, it is preferable that the component B, the component D, and the optional component are sequentially charged into a container filled with purified pure water with stirring, the pH of the mixed solution is adjusted by adding the component C and the pH adjusting agent as necessary, and then the component A is added thereto. In a case where the water and the respective components are charged into the container, the water and the respective components may be charged at once, or may be charged in a divided manner a plurality of times.

As a stirring device and a stirring method used for preparing the composition, a known device may be used as a stirrer or a disperser. Examples of the stirrer include an industrial mixer, a portable stirrer, a mechanical stirrer, and a magnetic stirrer. Examples of the disperser include an industrial disperser, a homogenizer, an ultrasonic disperser, and a beads mill.

The mixing of the respective components in the step of preparing the composition, a refining treatment described later, and storage of the produced composition are preferably performed at 40°C or lower, and more preferably performed at 30°C or lower. The lower limit thereof is preferably 5°C or higher and more preferably 10°C or higher. By performing the preparation, treatment, and/or storage of the composition within the above-described temperature range, the performance can be stably maintained for a long period of time.

### <Purification treatment>

It is preferable to subject any one or more of the raw materials for preparing the composition to a purification treatment in advance. Examples of the purification treatment include known methods such as distillation, ion exchange, and filtration (filtering).

Regarding a degree of purification, it is preferable to carry out the purification treatment until the purity of the raw material is 99% by mass or more, and it is more preferable to carry out the purification treatment until the purity of the stock solution is 99.9% by mass or more. The upper limit thereof is preferably 99.9999% by mass or less.

Examples of a method of the purification treatment include a method of allowing the raw material to flow through an ion exchange resin, a reverse osmosis membrane (RO membrane), or the like, distillation of the raw material, and filtering described later.

The purification treatment may be carried out by combining a plurality of the above-described purification methods. For example, the raw materials are subjected to primary purification by passing through an RO membrane, and then subjected to secondary purification by passing through a purification device consisting of a cation-exchange resin, an anion-exchange resin, or a mixed-bed type ion exchange resin.

In addition, the purification treatment may be performed a plurality of times.

### (Filtering)

Examples of a filter used for the filtering include known filters for filtration. Examples thereof include filters formed of fluororesins such as polytetrafluoroethylene (PTFE) and tetrafluoroethylene perfluoroalkyl vinyl ether copolymer (PFA), polyamide-based resins such as nylon, polyolefin resins (including those with a high density and a ultra-high molecular weight) such as polyethylene and polypropylene (PP), or the like.

Among these materials, a material selected from the group consisting of polyethylene, polypropylene (including a high-density polypropylene), a fluororesin (including PTFE and PFA), and a polyamide-based resin (including nylon) is preferable, and a filter of the fluororesin is more preferable. By carrying out filtering of the raw materials using a filter formed of these materials, high-polarity foreign matters which are likely to cause defects can be more effectively removed.

A critical surface tension of the filter is preferably 70 to 95 mN/m and more preferably 75 to 85 mN/m. The value of the critical surface tension of the filter is a nominal value of a manufacturer. In a case of using a filter having a critical surface tension in the above-described range, it is possible to effectively remove high-polarity foreign matters which are likely to cause defects.

A pore diameter of the filter is preferably 2 to 20 nm and more preferably 2 to 15 nm. Within the range, it is possible to reliably remove fine foreign matters such as impurities and aggregates contained in the raw materials while suppressing clogging in filtering. With regard to the pore diameter of the filter herein, a nominal value of the filter manufacturer can be referred to.

The filtering may be carried out only once or twice or more. In a case where the filtering is carried out twice or more, the filters used may be the same or different from each other.

In addition, a temperature of the filtering is preferably room temperature (25°C) or lower, more preferably 23°C or lower, and still more preferably 20°C or lower. In addition, the lower limit thereof is preferably 0°C or higher, more preferably 5°C or higher, and still more preferably 10°C or higher. In a case of carrying out the filtering in the above-described temperature range, it is possible to reduce the amounts of particulate foreign matter and impurities dissolved in the raw material and to efficiently remove the foreign matter and impurities.

### <Container>

The composition (including an aspect of a diluted liquid described later) can be added in any container to be stored and transported as long as problems such as corrosiveness do not arise.

In application for a semiconductor, the container is preferably a container which has a high degree of cleanliness inside the container and in which the elution of impurities from an interior wall of an accommodating portion of the container into the each liquid is suppressed. Examples of such a container include various containers commercially available as a container for a semiconductor composition, such as "CLEAN BOTTLE" series manufactured by AICELLO MILIM CHEMICAL Co., Ltd. and "PURE BOTTLE" manufactured by Kodama Plastics Co., Ltd., but the container is not limited thereto.

In addition, the container accommodating the composition is preferably a container in which a liquid contact portion with each liquid, such as the interior wall of the accommodating portion of the container, is made of a fluororesin (perfluororesin) or metal subjected to an antirust treatment and a metal elution prevention treatment.

The interior wall of the container is preferably formed from one or more resins selected from the group consisting of a polyethylene resin, a polypropylene resin, and a polyethylene-polypropylene resin; another resin different from these resins; or a metal which has been subjected to an antirust treatment and a metal elution prevention treatment, such as stainless steel, Hastelloy, Inconel, and Monel.

The above-described different resin is preferably a fluororesin (perfluororesin). As described above, in a case where a container having an interior wall formed of a fluororesin is used, occurrence of problems such as elution of an ethylene or propylene oligomer can be further suppressed than in a case where a container having an interior wall formed of a polyethylene resin, a polypropylene resin, or a polyethylene-polypropylene resin is used.

Examples of such a container having an interior wall formed of a fluororesin include a FluoroPure PFA composite drum manufactured by Entegris. In addition, containers described in page 4 of JP1991-502677A (JP-H3-502677A), in page 3 of WO2004/016526A, in pages 9 and 16 of WO99/046309A, or the like can also be used.

In addition, other than the above-described fluororesin, it is also preferable that quartz or a metal material finished up with electropolishing (that is, electropolished metal material) is used in the interior wall of the container.

The metal material which is used for producing the above-described electropolished metal material is preferably a metal material which includes at least one selected from the group consisting of chromium and nickel, and has a total content of chromium and nickel of more than 25% by mass with respect to the total mass of the metal material, and examples thereof include stainless steel and a nickel-chromium alloy.

The total content of chromium and nickel in the metal material is more preferably 30% by mass or more with respect to the total mass of the metal material. The upper limit thereof is preferably 90% by mass or less.

As a method for electropolishing the metal material, a known method can be used. For example, methods described in paragraphs [0011] to [0014] of JP2015-227501A, paragraphs [0036] to [0042] of JP2008-264929A, or the like can be used.

The inside of these containers is preferably cleaned before filling the composition. With regard to a liquid used for the cleaning, the amount of metal impurities in the liquid is preferably reduced. The composition may be bottled in a container such as a gallon bottle and a coated bottle after the production, and then may be transported and stored.

In order to prevent changes in the components of the composition during the storage, the inside of the container may be purged with an inert gas (such as nitrogen and argon) having a purity of 99.99995% by volume or more. In particular, a gas with a low moisture content is preferable. In addition, during the transportation and the storage, the temperature may be normal temperature or may be controlled in a range of -20°C to 20°C to prevent deterioration.

### (Clean room)

It is preferable that handlings such as production of the composition, opening and cleaning of the container, and filling of the composition, treatment analysis, and measurements are all performed in a clean room. It is preferable that the clean room meets the 14644-1 clean room standard. Among these, it is more preferable that the clean room satisfies any one of International Organization for Standardization (ISO) class 1, ISO class 2, ISO class 3, ISO class 4, ISO class 5, or ISO class 6; it is still more preferable that the clean room satisfies any one of ISO class 1, ISO class 2, ISO class 3, or ISO class 4; it is particularly preferable that the clean room satisfies ISO class 1 or ISO class 2; and it is most preferable that the clean room satisfies ISO class 1.

### <Dilution step>

The composition may be used for cleaning the semiconductor substrate as a diluted composition (diluted liquid) which has been diluted after undergoing a dilution step of diluting the composition with a diluent such as water.

The diluted liquid is also an aspect of the composition according to the embodiment of the present invention as long as the requirements of the present invention are satisfied.

A dilution ratio of the composition in the dilution step may be appropriately adjusted according to the type and content of each component and the application target such as the semiconductor substrate, but a ratio (dilution ratio) of the diluted liquid to the composition before the dilution is, for example, 10 to 1,000, preferably 30 to 400 and more preferably 50 to 300 in terms of mass ratio or volume ratio (volume ratio at 25°C).

In particular, in a case of being used as various cleaning liquids, the composition is preferably diluted to 30 times or more, more preferably 50 times or more, and still more preferably 100 times or more.

In addition, a suitable content of each component (excluding water) with respect to the total mass of the diluted liquid is an amount obtained by dividing the amount described as the suitable content of each component with respect to the total mass of the composition (composition before the dilution) by the dilution ratio (for example, 100) within the above-described range.

A preferred range of a pH of the diluted liquid is the same as the preferred range of the pH of the composition described above.

An electrical conductivity of the diluted liquid is not particularly limited, but is preferably 0.1 to 1.0 mS/cm and more preferably 0.2 to 0.6 mS/cm.

A method for measuring and adjusting the electrical conductivity of the diluted liquid is the same as the method for measuring and adjusting the composition. The electrical conductivity of the diluted liquid can also be adjusted by the dilution ratio.

A specific method of the dilution step of diluting the composition may be carried out according to the preparing step of the composition described above. A stirring device and a stirring method used in the dilution step may also be performed using the known stirring device mentioned in the step of preparing the composition described above.

It is preferable to subject the water which is used in the dilution step to a purification treatment in advance. In addition, it is preferable to carry out the purification treatment on the diluted liquid obtained by the dilution step.

Examples of the purification treatment include the ion component reducing treatment using the ion exchange resin, the RO membrane, or the like, and the foreign matter removal using filtering, which are described as the purification treatment for the composition above, and it is preferable to carry out any one of these treatments.

### [Applications of composition]

Next, applications of the composition will be described.

The composition can be used as a composition used in a manufacturing process of a semiconductor element. That is, the composition can be used in any step of manufacturing a semiconductor element.

Examples of the applications of the composition include a cleaning liquid used for cleaning a semiconductor substrate (cleaning liquid for a semiconductor substrate), a cleaning liquid used for cleaning a member used for manufacturing a semiconductor substrate (cleaning liquid for a member), and a treatment liquid used for removing a target object on a semiconductor substrate, such as a metal-containing substance (treatment liquid for a semiconductor substrate).

The above-described cleaning liquid for a semiconductor substrate is not particularly limited as long as it is a cleaning liquid used for removing residues adhering to the semiconductor substrate, such as metal impurities and fine particles; and examples thereof include a cleaning liquid for a semiconductor substrate which has been subjected to a chemical mechanical polishing (CMP) treatment (pCMP cleaning liquid), a cleaning liquid for a buff cleaning of a semiconductor substrate which has been subjected to a CMP treatment (cleaning liquid for buff cleaning), a cleaning liquid for a semiconductor substrate which has been subjected to a back grinding, a cleaning liquid for a semiconductor substrate which has been subjected to an etching treatment (post-etching residue cleaning liquid), and a cleaning liquid for a semiconductor substrate which has been subjected to soldering of an electronic component or which has been subjected to a flux treatment to form a solder bump.

Examples of the cleaning liquid for a member include a cleaning liquid for cleaning a target object such as a member which comes into contact with a semiconductor substrate in a manufacturing process of a semiconductor element and a member which comes into contact with a pre-treatment liquid before being applied to a semiconductor substrate. More specific examples thereof include a cleaning liquid for a cleaning brush used for cleaning a semiconductor substrate which has been subjected to the CMP treatment (cleaning liquid for a brush), a cleaning liquid for a polishing pad used for the CMP treatment of the semiconductor substrate (cleaning liquid for a pad), a cleaning liquid for cleaning a resin product such as a storage container of the semiconductor substrate (cleaning liquid for a resin product), a cleaning liquid for cleaning a glass substrate (cleaning liquid for a glass substrate), and a cleaning liquid for a mechanical cleaning.

Examples of the above-described treatment liquid for a semiconductor substrate include an etchant which dissolves and removes a metal-containing substance on the semiconductor substrate, a pre-wetting liquid which is applied to the substrate in order to improve coating properties of an actinic ray-sensitive or radiation-sensitive composition before a step of forming a resist film using the actinic ray-sensitive or radiation-sensitive composition, and a rinsing liquid which is used for rinsing off a substance adhering to the semiconductor substrate.

For example, in a case where the composition is applied onto the object such as the semiconductor substrate, the cleaning brush, and the polishing pad mentioned in the above-described examples of the applications after a predetermined period of time has elapsed from the production, the composition exhibits the effect of excellent removal performance of residues.

The composition may be used in only one application or two or more of applications among the above-described applications.

Examples of a method for using the composition for the above-described applications include a method of bringing the composition into contact with an object of the above-described applications. As a result, it is possible to carry out cleaning of an object (removal of residues on the object, and the like) or removal of one or more kinds of metal-containing substances contained in the object.

More specific examples thereof include a cleaning method of removing residues adhering to the object (for example, a method of cleaning a semiconductor substrate subjected to CMP) using the composition. In addition, examples thereof also include an etching treatment method of dissolving and removing a metal-containing substance on the object using the composition, a pre-wetting treatment method of applying the composition onto the semiconductor substrate before the step of forming a resist film using an actinic ray-sensitive or radiation-sensitive composition, and a rinsing treatment method of rinsing the semiconductor substrate using the composition.

### [Semiconductor substrate]

Hereinafter, the semiconductor substrate will be described.

In the following description, a configuration of the semiconductor substrate will be described with representative examples of using the composition by bringing the composition into contact with the semiconductor substrate; but the application aspect of the composition is not limited to the following description. As described above, the member to be cleaned by the composition or the semiconductor substrate to be contacted by the treatment liquid, the treatment liquid being in contact with the member to be cleaned by the composition, may be the semiconductor substrate as described below.

Examples of the semiconductor substrate which is one of the objects to which the composition is applied include a semiconductor substrate having a metal-containing substance on the semiconductor substrate.

In the present specification, the "on the semiconductor substrate" includes, for example, both the front and back surfaces, the side surfaces, and the inside of the groove of the semiconductor substrate. In addition, a metal-containing substance on the semiconductor substrate encompasses not only a case where the metal-containing substance is directly on the surface of the semiconductor substrate but also a case where the metal-containing substance is present on the semiconductor substrate through another layer.

The semiconductor substrate may have two or more kinds of metal-containing substances.

The metal-containing substance may be a substance containing a metal (metal atom).

Examples of a metal contained in the metal-containing substance include at least one metal M selected from the group consisting of Cu (copper), Al (aluminum), Ru (ruthenium), Co (cobalt), W (tungsten), Ti (titanium), Ta (tantalum), Cr (chromium), Hf (hafnium), Os (osmium), Pt (platinum), Ni (nickel), Mn (manganese), Zr (zirconium), Mo (molybdenum), La (lanthanum), and Ir (iridium).

Examples of the metal-containing substance include a single body of the metal M, an alloy containing the metal M, an oxide of the metal M, a nitride of the metal M, and an oxynitride of the metal M. The metal-containing substance may be a mixture containing two or more of these compounds. In addition, the oxide, nitride, and oxynitride described above may be any of a composite oxide, a composite nitride, or a composite oxynitride, each of which contains a metal.

A content of the metal atom in the metal-containing substance is preferably 10% by mass or more, more preferably 30% by mass or more, and still more preferably 50% by mass or more with respect to the total mass of the metal-containing substance. The upper limit is preferably 100% by mass or less.

The semiconductor substrate preferably has the metal M-containing substance containing the metal M; more preferably has a metal-containing substance containing at least one metal selected from the group consisting of Cu, Al, W, Co, Ti, Ta, Ru, and Mo; still more preferably has a metal-containing substance containing at least one metal selected from the group consisting of W, Co, Cu, Al, Ti, Ta, and Ru; and particularly preferably has a W-containing substance containing W.

Examples of the semiconductor substrate include a semiconductor substrate having a metal wiring line film, a barrier metal, and an insulating film on a surface of a wafer constituting the substrate.

Examples of the wafer constituting the substrate include a wafer consisting of a silicon-based material, such as a silicon (Si) wafer, a silicon carbide (SiC) wafer, and a silicon-including resin-based wafer (glass epoxy wafer), a gallium phosphorus (GaP) wafer, a gallium arsenic (GaAs) wafer, and an indium phosphorus (InP) wafer.

Examples of the silicon wafer include an n-type silicon wafer in which a silicon wafer is doped with a pentavalent atom (for example, phosphorus (P), arsenic (As), antimony (Sb), or the like) and a p-type silicon wafer in which a silicon wafer is doped with a trivalent atom (for example, boron (B), gallium (Ga), or the like). Examples of the silicon of the silicon wafer include amorphous silicon, single crystal silicon, polycrystalline silicon, and polysilicon.

Among these, a wafer consisting of a silicon-based material, such as a silicon wafer, a silicon carbide wafer, and a resin-based wafer (a glass epoxy wafer) including silicon, is preferable.

The semiconductor substrate may have an insulating film on the above-described wafer.

Examples of the insulating film include a silicon oxide film (for example, a silicon dioxide (SiO₂) film, a tetraethyl orthosilicate (Si(OC₂H₅)₄) film (a TEOS film), a silicon nitride film (for example, silicon nitride (Si₃N₄), and silicon nitride carbide (SiNC)), and a low-dielectric-constant (Low-k) film (for example, a carbon-doped silicon oxide (SiOC) film and a silicon carbide (SiC) film); and a low-dielectric-constant (Low-k) film is preferable.

The semiconductor substrate usually has a metal film containing a metal as a metal wiring line film, a barrier metal, or another film.

The metal film included in the semiconductor substrate is preferably a metal film containing the metal M; more preferably a metal film containing at least one metal selected from the group consisting of Cu, Al, W, Co, Ti, Ta, Ru, and Mo; and still more preferably a metal film containing at least one metal selected from the group consisting of W, Co, Cu, and Ru.

Examples of the metal film containing at least one metal selected from the group consisting of W, Co, Cu, and Ru include a film containing tungsten as a main component (a W-containing film), a film containing cobalt as a main component (a Co-containing film), a film containing copper as a main component (a Cu-containing film), and a film containing ruthenium as a main component (a Ru-containing film).

Among these, as the object of the composition, a semiconductor substrate having the W-containing film is preferable.

Examples of the W-containing film include a metal film consisting of only metal tungsten (W metal film) and a metal film made of an alloy consisting of tungsten and another metal (W alloy metal film). Examples of the tungsten alloy metal film include a tungsten-titanium alloy metal film (W and Ti-containing metal film) and a tungsten-cobalt alloy metal film (W and Co-containing metal film). The W-containing film is used, for example, as a barrier metal or a connecting portion between a via and a wiring line.

Examples of the Cu-containing film include a wiring line film consisting of only metal copper (Cu wiring line film) and a wiring line film made of an alloy consisting of metal copper and another metal (Cu alloy wiring line film).

Examples of the Co-containing film include a metal film consisting of only metal cobalt (Co metal film) and a metal film made of an alloy consisting of metal cobalt and another metal (Co alloy metal film).

Examples of the Ru-containing film include a metal film consisting of only metal ruthenium (Ru metal film) and a metal film made of an alloy consisting of metal ruthenium and another metal (Ru alloy metal film). The Ru-containing film is often used as a barrier metal.

A method for forming the above-described metal wiring line film, barrier metal, and insulating film on the wafer constituting the semiconductor substrate is not particularly limited as long as it is a method which is generally carried out in this field.

Examples of the method of forming the insulating film include a method in which the wafer constituting the semiconductor substrate is subjected to a heat treatment in the presence of oxygen gas to form a silicon oxide film, and then a gas of silane and ammonia is introduced thereto to form a silicon nitride film by a chemical vapor deposition (CVD) method.

Examples of the method of forming the W-containing film, the Cu-containing film, the Ru-containing film, and the Co-containing film include a method of forming a circuit on a wafer having the above-described insulating film by a known method such as a resist, and then forming a W-containing film, a Cu-containing film, an Ru-containing film, and a Co-containing film according to a method such as plating and a CVD method.

### <CMP treatment>

The semiconductor substrate may be a semiconductor substrate which has been subjected to a flattening treatment such as a CMP treatment after providing the insulating film, the barrier metal, and the metal film on the wafer.

In general, the CMP treatment is a treatment of flattening a surface of a semiconductor substrate with a combined action of a chemical action of components contained in a polishing liquid and polishing by mechanical friction, by attaching a polishing pad onto a circular surface plate for polishing (platen), immersing a surface of the polishing pad in a polishing liquid containing polishing fine particles (abrasive grains), pressing a surface of a semiconductor substrate having a metal film, a barrier metal, and an insulating film onto the surface of the attached polishing pad, and rotating both the surface plate for polishing and the substrate in a state where a predetermined pressure (polishing pressure) is applied from a back surface of the semiconductor substrate.

A surface of the semiconductor substrate, which has been subjected to the CMP treatment, may have impurities remaining thereon, such as abrasive grains (for example, silica and alumina) used in the CMP treatment, a polished metal film and/or metal impurities (metal residue) derived from the barrier metal. In addition, organic impurities derived from the polishing liquid used in the CMP treatment may remain. For example, since these impurities may cause a short-circuit between wiring lines and deteriorate electrical characteristics of the semiconductor substrate, the semiconductor substrate which has been subjected to the CMP treatment is subjected to a cleaning treatment for removing these impurities from the surface.

Examples of the semiconductor substrate which has been subjected to the CMP treatment include substrates which have been subjected to the CMP treatment, described in Journal of the Japan Society for Precision Engineering, Vol. 84, No. 3, 2018, but the semiconductor substrate is not limited thereto.

The polishing liquid is used in the CMP treatment.

As the polishing liquid used in the CMP treatment, known polishing liquids can be appropriately used depending on the type of the semiconductor substrate, the composition of the polishing liquid, and the type of the residues to be removed.

Examples of the polishing liquid include a polishing liquid containing iron ions and hydrogen peroxide, and a polishing liquid containing chemically modified colloidal silica (for example, cation-modified or anion-modified colloidal silica). In addition, examples of the polishing liquid also include the polishing liquids containing an iron complex, which are described in JP2020-068378A, JP2020-015899A, and US11043151B, and the polishing liquid containing chemically modified colloidal silica, which is described in JP2021-082645A, the contents of which are incorporated in the present specification.

The polishing pad which can be used in the CMP treatment is not particularly limited.

Examples of a constituent material of the polishing pad include a thermoplastic resin or an elastomer, and a polyurethane resin (more preferably a foamed polyurethane resin). In addition, a polishing pad including a nonwoven fabric impregnated with a polyurethane resin, and a polishing pad having a suede-like surface can also be used. A polishing pad including a polyurethane resin is preferable from the viewpoint that hydrophilicity is high and immersion in the polishing liquid is easy.

As a commercially available product thereof, for example, a polishing pad made of a thermoplastic resin or an elastomer can be available from JSR Corporation, and a polishing pad made of a polyurethane resin can be available from NITTA DuPont Incorporated.

### <Buffing cleaning>

The semiconductor substrate may be a semiconductor substrate which has been subjected to a CMP treatment and then subjected to a buffing cleaning.

The buffing cleaning is a treatment of reducing impurities on the surface of the semiconductor substrate using a polishing pad. Specifically, a polished surface of a semiconductor substrate which has been subjected to the CMP treatment is pressed onto a surface of the polishing pad attached to the circular platen to bring the polishing pad into contact with the semiconductor substrate, and then the semiconductor substrate and the polishing pad are allowed to relatively slide while supplying a cleaning liquid for buffing cleaning to a contact portion therebetween. By the treatment, the impurities on the surface of the semiconductor substrate subjected to the CMP treatment are removed by a frictional force due to the polishing pad and a chemical action due to the cleaning liquid.

As the cleaning liquid for buffing cleaning, a known cleaning liquid for buffing cleaning can be appropriately used depending on the type of the semiconductor substrate and the type and amount of impurities to be removed. Examples of components contained in the cleaning liquid for buff cleaning include a water-soluble polymer such as polyvinyl alcohol, water as a dispersion medium, and an acid such as nitric acid.

As will be described later, the semiconductor substrate may be subjected to the buffing cleaning using the composition as a cleaning liquid for buffing cleaning.

A polishing device, polishing conditions, and the like, which are used in the buff cleaning, can be appropriately selected from known devices and conditions according to the type of the semiconductor substrate, the object to be removed, and the like. Examples of the buffing cleaning include treatments described in paragraphs [0085] to [0088] of WO2017/169539A, the content of which is incorporated herein by reference.

Hereinafter, among applications of the above-described composition, each application of a cleaning liquid for a semiconductor substrate (preferably a CMP-treated semiconductor substrate), a cleaning liquid for a brush used for cleaning a CMP-treated semiconductor substrate, a cleaning liquid for a polishing pad used in a CMP treatment of a semiconductor substrate, and a cleaning liquid for buff cleaning of a CMP-treated semiconductor substrate will be described in detail.

The CMP-treated semiconductor substrate used for the above-described applications is not particularly limited as long as it is the semiconductor substrate described above, but a semiconductor substrate containing tungsten is preferable and a semiconductor substrate having a W-containing film is more preferable.

### [First application: cleaning of CMP-treated semiconductor substrate]

The composition can be used as a cleaning liquid for a semiconductor substrate in a cleaning method of a semiconductor substrate, which includes a step of cleaning a CMP-treated semiconductor substrate (hereinafter, also referred to as "first application"). That is, the composition can be used as a cleaning liquid used for a CMP-treated semiconductor substrate in a manufacturing method of a semiconductor element, which includes a step of subjecting a semiconductor substrate with a CMP treatment and a step of cleaning the CMP-treated semiconductor substrate.

The composition can be applied to a known method performed on the CMP-treated semiconductor substrate.

The composition used for the first application may be a diluted liquid obtained in the above-described dilution step, and it is also preferable to include a step of applying the diluted liquid to the CMP-treated semiconductor substrate to carry out cleaning.

A cleaning step of cleaning the semiconductor substrate subjected to the CMP treatment is not particularly limited as long as it is a method of cleaning the semiconductor substrate by bringing a composition into contact with the semiconductor substrate. Known methods in the field of manufacturing a semiconductor element, such as scrub in which a cleaning member such as a brush is physically brought into contact with a surface of a semiconductor substrate while supplying a composition to the semiconductor substrate, an immersion type in which a semiconductor substrate is immersed in a composition, a spin (dropwise addition) type in which a composition is added dropwise while rotating a semiconductor substrate, and a spraying (spray) type in which a composition is sprayed, are appropriately employed.

In the cleaning of the semiconductor substrate, a mechanical stirring method may be used in order to further reduce the impurities remaining on the surface of the semiconductor substrate and further enhance the cleaning ability of the composition. Examples of the mechanical stirring method include a method of circulating the composition on the semiconductor substrate, a method of flowing or spraying the composition on the semiconductor substrate, and a method of stirring the composition with ultrasonic or megasonic.

The above-described cleaning step may be carried out only once or twice or more. In a case of carrying out the cleaning two or more times, the same method may be repeated or different methods may be combined.

The cleaning method of a semiconductor substrate may be a single-wafer method or a batch method.

The single-wafer method is generally a method of treating semiconductor substrates one by one, and the batch method is generally a method of treating a plurality of semiconductor substrates at the same time.

A temperature of the composition which is used for cleaning the semiconductor substrate is not particularly limited as long as it is a temperature which is usually used in this field. The cleaning is generally carried out at room temperature (approximately 25°C), but any temperature can be selected in order to improve cleanability and suppress damage to the member. The temperature of the composition is preferably 10°C to 60°C and more preferably 15°C to 50°C.

A cleaning time in the cleaning of the semiconductor substrate can be appropriately changed depending on the type, content, and the like of the components contained in the composition. Practically, the cleaning time is preferably 10 to 120 seconds, more preferably 20 to 90 seconds, and still more preferably 30 to 60 seconds.

A supply amount (supply rate) of the composition in the cleaning step of the semiconductor substrate is preferably 50 to 5,000 mL/min and more preferably 500 to 2,000 mL/min.

Preferred aspects of the composition used for the first application are as follows.

The pH of the composition is 4.0 to 9.0, and it is preferable to be within the above-described preferred range of the pH of the composition.

The composition used for the first application may be a diluted liquid obtained in the above-described dilution step. In a case where the diluted liquid is used, a dilution ratio thereof is preferably 10 times or more, more preferably 30 times or more, still more preferably 50 times or more, and particularly preferably 100 times or more in terms of mass ratio. The upper limit thereof is not particularly limited, but is preferably 1,000 times or less, more preferably 400 times or less, and still more preferably 300 times or less. The pH of the diluted liquid is 4.0 to 9.0, and it is preferable to be within the above-described preferred range of the pH of the diluted liquid.

A ratio B/A of the content of the citric acid to the content A of the sorbic acid in the composition is preferably 1 to 50, and is preferably within the above-described preferred range of the ratio B/A. In addition, a ratio C/A of the content of the component C to the content A of the sorbic acid in the composition is preferably 10 to 500, and is preferably within the above-described preferred range of the ratio C/A.

The electrical conductivity of the composition at 25°C is preferably 0.05 mS/cm or more and more preferably 0.1 to 20 mS/cm.

After the above-described cleaning of the semiconductor substrate, a step of rinsing and washing the semiconductor substrate with a solvent (hereinafter, also referred to as "rinsing step") may be carried out.

The rinsing step is preferably a step which is carried out continuously subsequently after the cleaning step of the semiconductor substrate, in which the rinsing is carried out with a rinsing liquid for 5 to 300 seconds. The rinsing step may be carried out using the above-described mechanical stirring method.

Examples of the rinsing liquid include water (preferably deionized (DI) water), methanol, ethanol, isopropyl alcohol, N-methylpyrrolidinone, γ-butyrolactone, dimethyl sulfoxide, ethyl lactate, and propylene glycol monomethyl ether acetate. In addition, an aqueous rinsing liquid having a pH of more than 8.0 (diluted aqueous ammonia water or the like) may be used.

As a method of bringing the rinsing liquid into contact with the semiconductor substrate, the above-described method of bringing the composition into contact with the semiconductor substrate can be similarly adopted.

In addition, after the above-described rinsing step, a drying step of drying the semiconductor substrate may be carried out.

Examples of the drying method include a spin drying method, a method of flowing a dry gas onto a semiconductor substrate, a method of heating a substrate by a heating unit such as a hot plate and an infrared lamp, a Marangoni drying method, a Rotagoni drying method, an isopropyl alcohol (IPA) drying method, and a method of combining any of these methods.

### [Second application: cleaning of cleaning brush]

The composition can be used as a cleaning liquid for a brush in a cleaning method of a cleaning brush, which includes a step of cleaning a cleaning brush used for cleaning a CMP-treated semiconductor substrate (hereinafter, also referred to as "second application").

Examples of the cleaning brush which is an object to be cleaned for the second application include known brushes used for scrub cleaning, in which the cleaning brush is physically brought into contact with a surface of the semiconductor substrate to remove residues and the like.

A shape of the cleaning brush is not particularly limited, examples thereof include a cylindrical roll type brush and a pencil type brush, and a roll type brush is preferable. In addition, in many cases, the cleaning brush has a large number of columnar protrusions protruding in a radial direction on the surface.

Examples of a constituent material of the cleaning brush include polymer resins having a hydroxyl group, such as a polyvinyl alcohol (PVA) resin, a polyurethane resin, and a polyolefin resin. As the cleaning brush, a cleaning brush consisting of a sponge-like material of the above-described polymer resin is preferable, and a cleaning brush consisting of a sponge-like material of the PVA resin is more preferable.

Examples of a commercially available product of the cleaning brush include brushes manufactured by Entegris (for example, model "PVP1ARXR1") and brushes manufactured by AION Co., Ltd. (Bell-eater (registered trademark) A series).

As the cleaning method of the cleaning brush using the composition, a known method carried out in the field of manufacturing a semiconductor element, such as the immersion and spray described as the cleaning step of the semiconductor substrate in the above-described first application is appropriately adopted.

In addition, cleaning conditions including the temperature and cleaning time of the cleaning liquid can also be appropriately selected with reference to the cleaning conditions in the above-described cleaning step of the semiconductor substrate and known cleaning methods, based on the constituent material of the cleaning brush.

Preferred aspects of the composition used for the second application are as follows.

The pH of the composition is 4.0 to 9.0, and it is preferable to be within the above-described preferred range of the pH of the composition.

The composition used for the second application may be a diluted liquid obtained in the above-described dilution step. A dilution ratio in a case of using a diluted liquid is preferably 10 to 100 times and more preferably 30 to 100 times in terms of mass ratio. The pH of the diluted liquid is 4.0 to 9.0, and it is preferable to be within the above-described preferred range of the pH of the diluted liquid.

A ratio B/A of the content of the citric acid to the content A of the sorbic acid in the composition is preferably 1 to 50, and is preferably within the above-described preferred range of the ratio B/A. In addition, a ratio C/A of the content of the component C to the content A of the sorbic acid in the composition is preferably 10 to 500, and is preferably within the above-described preferred range of the ratio C/A.

The electrical conductivity of the composition at 25°C is preferably 0.05 mS/cm or more and more preferably 0.1 to 10 mS/cm.

### [Third application: cleaning of polishing pad]

The composition can be used as a cleaning liquid for a polishing pad in a cleaning method of a polishing pad, which includes a step of cleaning a polishing pad used for a CMP treatment of a semiconductor substrate (hereinafter, also referred to as "third application").

The polishing pad which is an object to be cleaned for the third application is not particularly limited as long as it is a known polishing pad used for the CMP treatment of a semiconductor substrate, and examples thereof include the polishing pad described in <CMP treatment> above. Among these, a polishing pad including a polyurethane resin is preferable.

As the cleaning method of the polishing pad, a known method carried out in the field of manufacturing a semiconductor element, such as the immersion and spray described as the cleaning step of the semiconductor substrate in the above-described first application is appropriately adopted.

In addition, cleaning conditions including the temperature and cleaning time of the cleaning liquid can also be appropriately selected with reference to the cleaning conditions in the above-described cleaning step of the semiconductor substrate and known cleaning methods, based on the constituent material of the polishing pad.

Preferred aspects of the composition used for the third application are as follows.

The pH of the composition is 4.0 to 9.0, and it is preferable to be within the above-described preferred range of the pH of the composition.

The composition used for the third application may be a diluted liquid obtained in the above-described dilution step. A dilution ratio in a case of using a diluted liquid is preferably 10 to 100 times, more preferably 30 to 100 times, and still more preferably 50 to 100 times in terms of mass ratio. The pH of the diluted liquid is 4.0 to 9.0, and it is preferable to be within the above-described preferred range of the pH of the diluted liquid.

A ratio B/A of the content of the citric acid to the content A of the sorbic acid in the composition is preferably 1 to 50, and is preferably within the above-described preferred range of the ratio B/A. In addition, a ratio C/A of the content of the component C to the content A of the sorbic acid in the composition is preferably 10 to 500, and is preferably within the above-described preferred range of the ratio C/A.

The electrical conductivity of the composition at 25°C is preferably 0.05 mS/cm or more and more preferably 0.1 to 10 mS/cm.

### [Fourth application: buff cleaning]

The composition can be used as a cleaning liquid for buff cleaning in a cleaning method of a semiconductor substrate, which includes a buff cleaning step in which a polishing pad is brought into contact with a surface of a CMP-treated semiconductor substrate to clean the surface of the semiconductor substrate (hereinafter, also referred to as "fourth application").

A specific method of the buff cleaning for the fourth application is as described above in <Buff cleaning>. In addition, the polishing pad used for the buff cleaning of the fourth application is as described above in <CMP treatments

Preferred aspects of the composition used for the fourth application are as follows.

The pH of the composition is 4.0 to 9.0, and it is preferable to be within the above-described preferred range of the pH of the composition.

The composition used for the fourth application may be a diluted liquid obtained in the above-described dilution step. A dilution ratio in a case of using a diluted liquid is preferably 10 to 100 times, more preferably 30 to 100 times, and still more preferably 50 to 100 times in terms of mass ratio. The pH of the diluted liquid is 4.0 to 9.0, and it is preferable to be within the above-described preferred range of the pH of the diluted liquid.

A ratio B/A of the content of the citric acid to the content A of the sorbic acid in the composition is preferably 1 to 50, and is preferably within the above-described preferred range of the ratio B/A. In addition, a ratio C/A of the content of the component C to the content A of the sorbic acid in the composition is preferably 10 to 500, and is preferably within the above-described preferred range of the ratio C/A.

The electrical conductivity of the composition at 25°C is preferably 0.05 mS/cm or more and more preferably 0.2 to 20 mS/cm.

It is preferable that the composition used for the fourth application contains substantially no abrasive grains.

### [Other Applications]

The composition can also be used in applications different from any of the applications of cleaning of the CMP-treated semiconductor substrate, cleaning of the cleaning brush used for cleaning the CMP-treated semiconductor substrate, cleaning of the polishing pad used in the CMP treatment of a semiconductor substrate, and buff cleaning of the CMP-treated semiconductor substrate.

### <Cleaning of semiconductor substrate which has been subjected to back grinding>

For the purpose of reducing the size and thickness of a semiconductor device, there is known a technique (back grinding) of reducing a thickness of a wafer by grinding a surface of the semiconductor substrate opposite to a circuit forming surface.

The composition can be used as a cleaning liquid in a cleaning step of cleaning a semiconductor substrate which has been subjected to back grinding. By using the composition, it is possible to remove residues generated by back-grinding and an etching treatment associated with the back grinding.

### <Cleaning of semiconductor substrate which has been subjected to etching treatment>

In a process of manufacturing a semiconductor element, in a case where a metal layer and/or an insulating layer of a semiconductor substrate is etched by plasma etching using a resist pattern as a mask, residues derived from a photoresist, the metal layer, and the insulating layer are generated on the semiconductor substrate. In addition, in a case where a resist pattern which has been unnecessary is removed by plasma ashing, residues derived from the ashing photoresist are generated on the semiconductor substrate.

The composition can be used as a cleaning liquid in a cleaning step of cleaning a semiconductor substrate which has been subjected to an etching treatment. By using the composition, it is possible to remove the etching residues and/or the ashing residues, which are generated on the semiconductor substrate subjected to the etching treatment.

### <Cleaning of flux residue on semiconductor substrate>

In a case where an electronic component is mounted on a semiconductor substrate by soldering, a flux (accelerator) that removes an oxide which interferes with a connection between a metal such as an electrode or a wiring line and a solder metal and promotes the connection is used. In such a substrate on which the electronic component is soldered using the flux and/or a substrate with a solder bump for soldering the electronic component, which is formed using the flux, residues derived from the flux may remain.

The composition can be used as a cleaning liquid for cleaning a semiconductor substrate on which the electronic component is soldered using the flux or a semiconductor substrate on which the solder bump is formed using the flux. By using the composition, it is possible to remove the residues derived from the flux remaining on the semiconductor substrate.

### <Cleaning of semiconductor substrate which has been subjected to etching treatment>

In a process of manufacturing a semiconductor element, in a case where a metal layer and/or an insulating layer of a semiconductor substrate is etched by plasma etching using a resist pattern as a mask, residues derived from a photoresist, the metal layer, and the insulating layer are generated on the semiconductor substrate. In addition, in a case where a resist pattern which has been unnecessary is removed by plasma ashing, residues derived from the ashing photoresist are generated on the semiconductor substrate.

The composition can be used as a cleaning liquid in a cleaning step of cleaning a semiconductor substrate which has been subjected to an etching treatment. By using the composition, it is possible to remove the etching residues and/or the ashing residues, which are generated on the semiconductor substrate subjected to the etching treatment.

### <Cleaning of semiconductor substrate which has been subjected to bonding treatment>

In a process of manufacturing a semiconductor element, as a semiconductor chip manufactured by cutting (dicing) a wafer into a predetermined size, semiconductor chips held by a dicing film are picked up one by one, and sent to the next bonding step. During this dicing, foreign matters such as cutting shavings of the wafer and cutting shavings of the dicing film adhere to a surface of the semiconductor chip. In particular, in a bonding step such as flip-chip bonding in which the semiconductor chip is connected to the substrate through terminals arranged on the surface of the semiconductor chip, and direct bonding in which another semiconductor chip is directly bonded on top of the semiconductor chip, it has been known that the quality of bonding deteriorates due to minute foreign matter of several µm or less, and a cleaning treatment is carried out to remove the foreign matters from the semiconductor chip subjected to the bonding step.

The present composition can be used as a cleaning liquid in a cleaning step of cleaning a semiconductor chip before being subjected to the bonding step. By using the present composition, it is possible to remove, from the semiconductor chip, the foreign matters such as chips generated in the dicing step before the bonding step.

### <Cleaning of resin product>

The composition can be used for cleaning a resin product, particularly a resin container used for accommodating and transporting a semiconductor substrate in a process of manufacturing a semiconductor element.

In a case of accommodating and transporting a semiconductor substrate, a container for accommodating the semiconductor substrate is used to prevent intrusion of particles and to prevent chemical contamination. Examples of such a container include front opening shipping box (FOSB) used in a case of delivering wafers to semiconductor device manufacturers, and front opening unified pod (FOUP) and standard mechanical interface (SMIF) for storing wafers for transport between wafer processing steps. Here, in a case where an operation of storing the semiconductor substrate in the container and taking out the semiconductor substrate is repeated many times, metal impurities may be generated due to the contact between the semiconductor substrate and the inside of the container. In addition, the inside of the container may be contaminated with residues generated in the manufacturing process of the semiconductor element and remaining on the semiconductor substrate. The inside of the container is cleaned in order to prevent these metal impurities and residues from adhering to the semiconductor substrate.

By using the composition for cleaning the above-described container, it is possible to remove the etching residues and/or the ashing residues, which are generated on the semiconductor substrate subjected to the etching treatment.

### <Cleaning of glass substrate>

The composition can be used as a cleaning liquid for cleaning liquid a glass substrate, particularly a flat panel display such as a liquid crystal display, a plasma display, an organic EL display, and a touch panel, and a glass substrate suitable for a hard disk. By using the composition, it is possible to remove residues derived from metal impurities remaining on the glass substrate.

### <Etching treatment>

The composition can be used in an etching treatment for removing a metal film on a semiconductor substrate. Examples of the etching treatment include a method of dissolving and removing metal-containing substances on an object by bringing a composition into contact with the semiconductor substrate. The method of bringing the composition into contact with the semiconductor substrate is not particularly limited, and the method described in the first application can be adopted.

For specific aspects of the etching treatment, the description in paragraphs [0049] to [0069] of WO2019/138814A can be adopted, the contents of which are incorporated herein by reference.

All the treatments which are carried out according to the above-described application using the composition may be carried out in combination before or after other steps that are carried out in the manufacturing of the semiconductor element. The above-described treatment may be incorporated into other steps while carrying out the above-described treatment, or the above-described treatment may be incorporated between other steps.

Examples of the other steps include a step of forming each structure such as a metal wire, a gate structure, a source structure, a drain structure, an insulating layer, a ferromagnetic layer, and/or a non-magnetic layer (layer formation, etching, a CMP treatment, modification, or the like), a resist forming step, an exposure step and a removal step, a heat treatment step, a cleaning step, and an examination step.

The above-described treatment may be carried out at any stage of a back-end-of-the-line (BEOL) process, a middle-of-the-line (MOL) process, and a front-end-of-the-line (FEOL) process.

### Examples

Hereinafter, the present invention will be described in more detail with reference to Examples. The materials, the amounts of the materials to be used, the proportions, and the like shown in the Examples below may be modified as appropriate as long as the modifications do not depart from the spirit of the present invention. Therefore, the scope of the present invention is construed as being limited to Examples shown below.

In Examples below, the pH and the electrical conductivity of the composition were measured using a portable electrical conductivity and pH meter (manufactured by DKK-TOA CORPORATION, "WM-32EP"). The pH was measured at 25°C in accordance with JIS Z 8802-1984.

In the production of compositions of Examples and Comparative Examples, all of handling of a container, and preparation, filling, storage, and analytical measurement of the compositions were performed in a clean room satisfying a level of ISO Class 6 or lower.

### [Raw materials for composition]

The following compounds were used to produce a composition. As various components used in Examples, those all classified into a semiconductor grade or a high-purity grade equivalent thereto were used.
· Sorbic acid
· Citric acid

### [Component C]

· Tris (trishydroxymethylaminomethane)
· MEA (monoethanolamine)
· Ammonia
· TMAH (tetramethylammonium hydroxide)

### [Component D]

· HEDPO (1-hydroxyethylidene-1,1'-diphosphonic acid)
· NTPO (nitrilotris(methylenephosphonic acid))
· EDTPO (ethylenediaminetetra(methylenephosphonic acid))
· PBTCA (2-phosphonobutane-1,2,4-tricarboxylic acid)
· Phytic acid

In the production of the composition in the present example, the above-described component C was used as a pH adjusting agent, and commercially available ultrapure water (manufactured by FUJIFILM Wako Pure Chemical Corporation) was used as water.

### [Example 1]

### [Preparation example]

A composition 101 was prepared according to the following method.

Under stirring, citric acid and 1-hydroxyethylidene-1,1'-diphosphonic acid (HEDPO) were added to the ultrapure water, trishydroxymethylaminomethane (Tris) was added thereto, and then citric acid was added thereto. Each component was added in an amount of the formulation shown in Table 1. The obtained mixed solution was sufficiently stirred to obtain a composition 101.

Compositions 102 to 116 and comparative compositions 1 to 5, each having the formulation shown in Table 1, were produced according to the method of preparing the composition 101.

800 mL of a sample of each composition prepared by the above-described method was transferred to a "CLEANBARRIER BOTTLE" (manufactured by AICELLO CORPORATION, capacity: 1 L) under atmospheric pressure, and the bottle was sealed while leaving a space under atmospheric pressure in an upper part of the container. The container accommodating the sample was stored in a dark place environment of 25°C for 14 days.

The sample after the storage obtained in this manner was used in the following performance evaluation test.

### [Evaluation of anticorrosion properties]

A wafer (diameter: 12 inches) having a metal film made of tungsten (W) on a surface was cut to prepare a 2 cm-square wafer coupon. A thickness of the metal film (W film) was approximately 100 nm. The wafer coupon was immersed in 200 mL of the above-described sample (25°C), and while stirring at a stirring rotation speed of 250 rpm, an immersion treatment was performed for 30 minutes.

From a difference in thickness of the metal film measured before and after the immersion treatment, a film thickness of the metal film dissolved by the immersion treatment was calculated, and a corrosion rate of the metal film per unit time (unit: A/min) was calculated.

From the obtained corrosion rate of the metal film, anticorrosion properties of each sample with respect to tungsten were evaluated according to the following evaluation standard. The evaluation results are shown in Table 1.

As the corrosion rate of the W film was lower, the corrosion inhibiting performance of the composition with respect to tungsten was excellent. In practical use, an evaluation of "4" or more is desirable.

### (Evaluation standard for anticorrosion properties)

8: the corrosion rate was 0.3 Å/min or more.
7: the corrosion rate was more than 0.3 Å/min and 0.4 Å/min or less.
6: the corrosion rate was more than 0.4 Å/min and 0.5 Å/min or less.
5: the corrosion rate was more than 0.5 Å/min and 0.6 Å/min or less.
4: the corrosion rate was more than 0.6 Å/min and 0.7 Å/min or less.
3: the corrosion rate was more than 0.7 Å/min and 0.8 Å/min or less.
2: the corrosion rate was more than 0.8 Å/min and less than 1.0 Å/min.
1: the corrosion rate was 1.0 Å/min or more.

### [Evaluation of residue removability]

Using a polishing device ("FREX300II" manufactured by EBARA CORPORATION), a silicon wafer (diameter: 12 inches) having a CVD-W film (tungsten film) with a film thickness of 5,000 Å on a surface was subjected to a CMP treatment under the following conditions.
- Polishing liquid: polishing liquid obtained by adding hydrogen peroxide to a CMP slurry (trade name "W2000", manufactured by Cabot Corporation) in an amount of 2% by mass with respect to the total mass of the slurry

| | |
|---|---|
| · Table rotation speed: | 80 rpm |
| · Head rotation speed: | 78 rpm |
| · Polishing pressure: | 120 hPa |
| · Polishing pad: | "IC1400" manufactured by Rodel-Nitta |
| · Polishing liquid supply speed: | 250 mL/min |
| . Polishing time: | 60 seconds |

Each sample adjusted to room temperature (25°C) was used as a cleaning liquid, and the polished surface of the wafer subjected to the above-described CMP treatment was scrub-cleaned for 30 seconds. Thereafter, the cleaned wafer was rinsed with water and dried (dried out).

A defect detection device (manufactured by AMAT, ComPlus-II) was used for detecting a defect present on the polished surface of the wafer, and the type of each defect was specified by observing the defect with a scanning electron microscope (SEM) and by analyzing constituent elements with an energy-dispersive X-ray analyzer (EDAX). As a result, the number of defects based on residues due to the CMP treatment was obtained. The defects appeared in a square observation region of one side of 10 µm in three locations of a center part and two end parts sandwiching the center part were measured using an atomic force microscope (AFM) for measuring surface roughness, and the number of defects with a length of 0.1 µm or more based on the residues due to the CMP treatment was counted.

From the average number of the defects, obtained by adding and averaging the number of the defects per counted observation region, the residue removability of each sample with respect to the semiconductor substrate was evaluated based on the following standard. In practical use, an evaluation of "4" or more is desirable.

### (Evaluation standard for residue removability)

8: the average number of the defects per observation region was less than 20.
7: the average number of the defects per observation region was 20 or more and less than 30.
6: the average number of the defects per observation region was 30 or more and less than 40.
5: the average number of the defects per observation region was 40 or more and less than 50.
4: the average number of the defects per observation region was 50 or more and less than 60.
3: the average number of the defects per observation region was 60 or more and less than 80.
2: the average number of the defects per observation region was 80 or more and less than 100.
1: the average number of the defects per observation region was 100 or more.

### [Evaluation of wiring electrical properties]

Using a silicon wafer having a W film on a surface, a series of treatments consisting of the CMP treatment, the scrub cleaning using each sample, the rinsing, and the drying was performed according to the methods described in the evaluation test of the residue removability above.

Before and after the series of the treatments described above, a surface electrical resistance (sheet resistance value) of the W film of the silicon wafer was measured using a sheet resistance measuring device ("VR-120" manufactured by Kokusai Electric Semiconductor Service Inc.). A rate of change in sheet resistance value of the sheet resistance value (Ω/□) after the above-described treatment to the sheet resistance value (Ω/□) before the above-described treatment ({(Sheet resistance value of W film after treatment) - (Sheet resistance value of W film before treatment)}/(Sheet resistance value of W film before treatment) × 100) was calculated, and the influence of the treatment on the electrical properties of the W wiring line was evaluated based on the following standard. In practical use, an evaluation of "4" or more is desirable.

### (Evaluation standard for electrical properties)

8: the rate of change in sheet resistance value was less than 1%.
7: the rate of change in sheet resistance value was 1% or more and less than 1.2%.
6: the rate of change in sheet resistance value was 1.2% or more and less than 1.5%.
5: the rate of change in sheet resistance value was 1.5% or more and less than 1.7%.
4: the rate of change in sheet resistance value was 1.7% or more and less than 2.0%.
3: the rate of change in sheet resistance value was 2.0% or more and less than 2.5%.
2: the rate of change in sheet resistance value was 2.5% or more and less than 3%.
1: the rate of change in sheet resistance value was 3% or more.

Table 1 shows the formulation and physical properties of each composition, and the evaluation results by the above-described evaluations.

In the table, the column of "Amount (%)" indicates the content (unit: % by mass) of each component with respect to the total mass of the composition. The content of each component in the table indicates a content of each component as a compound. In addition, water is a remainder of components other than water, and in the table, a numerical value obtained by rounding off the third decimal place of a value is described as the content of water.

The numerical value in the column of "Ratio B/A" indicates a mass ratio of the content of the citric acid to the content of the sorbic acid (content of citric acid/content of sorbic acid); the numerical value in the column of "Ratio C/A" indicates a mass ratio of the content of the component C to the content of the sorbic acid (content of component C/content of sorbic acid); and the numerical value in the column of "Ratio B/C" indicates a mass ratio of the content of the citric acid to the content of the component C (content of citric acid/content of component C).

The column of "Phosphate ion (ppm)" indicates the content (unit: mass ppm) of the phosphate ion in each composition.

The numerical value in the column of "pH" indicates the pH of the composition at 25°C measured by the pH meter.

The numerical value in the column of "Electrical conductivity (mS/cm)" indicates the electrical conductivity (unit: mS/cm) of the composition measured with the above-described electrical conductivity meter. "*1" in the column of "Electrical conductivity (mS/cm)" indicates that the pH of the composition was low and thus the electrical conductivity could not be measured.

In the table, "-" indicates that the corresponding component was not contained in the composition.

**[Table 1]**

| | Composition | | | | | | | | | | | | | Evaluation | | |
|---|---|---|---|---|---|---|---|---|---|---|---|---|---|---|---|---|
| | Sorbic acid | Citric acid | Ratio B/A | Component C | | Ratio C/A | Ratio B/C | Component D | | Water | Phosphate ion (ppm) | pH | Electrical conductivity (mS/cm) | Residue removability | Anticorrosion properties | Wiring electrical properties |
| | Content (% by mass) | Content (% by mass) | | Type | Content (% by mass) | | | Type | Content (% by mass) | Content (% by mass) | | | | | | |
| Composition 101 | 0.06 | 0.38 | 6.33 | Tris | 6.50 | 108 | 0.058 | HEDPO | 420 | 88.86 | 1.0 | 5.91 | 12.96 | 7 | 7 | 8 |
| Composition 102 | 0.04 | 0.38 | 9.50 | Tris | 650 | 163 | 1058 | HEDPO | 420 | 88.88 | 1.0 | 5.91 | 12.97 | 7 | 7 | 8 |
| Composition 103 | 0.05 | 0.46 | 9.12 | Tris | 650 | 130 | 1070 | HEDPO | 420 | 88.79 | 1.0 | 5.85 | 12.96 | 8 | 7 | 8 |
| Composition 104 | 0.05 | 0.30 | 6.08 | Tris | 650 | 130 | 1047 | HEDPO | 4.20 | 88.95 | 1.0 | 6.02 | 12.75 | 7 | 7 | 8 |
| Composition 105 | 0.05 | 0.38 | 7.60 | Tris | 650 | 130 | 1058 | HEDPO | 504 | 88.03 | 1.0 | 4.67 | 11.25 | 8 | 7 | 8 |
| Composition 106 | 0.05 | 0.38 | 7.60 | Tris | 650 | 130 | 1058 | HEDPO | 3.36 | 89.71 | 1.0 | 6.88 | 12.38 | 7 | 7 | 8 |
| Composition 107 | 0.05 | 0.38 | 7.56 | Tris | 650 | 130 | 1058 | HEDPO | 420 | 88.87 | 1.0 | 5.91 | 13.12 | 8 | 8 | 8 |
| Composition 108 | 0.005 | 0.038 | 7.60 | Tris | 0.65 | 130 | 1058 | HEDPO | 0.42 | 98.89 | 1.0 | 6.08 | 10.53 | 7 | 8 | 7 |
| Composition 109 | 0.0005 | 0.0038 | 7.60 | Tris | 0.065 | 130 | 1058 | HEDPO | 0.042 | 99.89 | 1.0 | 6.83 | 0.395 | 7 | 8 | 6 |
| Composition 110 | 0.05 | 0.38 | 7.56 | MEA | 3.25 | 65 | 0.116 | HEDPO | 420 | 92.12 | 1.0 | 5.96 | 12.74 | 7 | 8 | 8 |
| Composition 111 | 0.05 | 0.38 | 7.56 | Ammonia | 1.63 | 33 | 7231 | HEDPO | 420 | 93.74 | 1.0 | 5.98 | 18.69 | 8 | 8 | 7 |
| Composition 112 | 0.05 | 0.38 | 7.56 | TMAH | 4.41 | 88 | 0.086 | HEDPO | 420 | 90.97 | 1.0 | 5.97 | 16.09 | 8 | 7 | 8 |
| Composition 113 | 0.05 | 0.38 | 7.56 | Tris | 11.19 | 224 | 0.034 | NTPO | 610 | 82.29 | 1.0 | 600 | 12.90 | 7 | 7 | 8 |
| Composition 114 | 0.05 | 0.38 | 7.56 | Tris | 5.81 | 116 | 0.065 | EDTPO | 17.78 | 75.98 | 1.0 | 6.00 | 12.10 | 7 | 6 | 8 |
| Composition 115 | 0.05 | 0.38 | 7.56 | Tris | 9.35 | 187 | 0.040 | PBTCA | 5.53 | 84.70 | 1.0 | 5.99 | 16.77 | 7 | 5 | 8 |
| Composition 116 | 0.05 | 0.38 | 7.56 | Tris | 1999 | 400 | 0.019 | Phytic acid | 13.46 | 66.12 | 1.0 | 5.99 | 1422 | 7 | 4 | 8 |
| Comparative Composition 1 | - | 0.38 | - | Tris | 650 | - | 0.060 | HEDPO | 420 | 88.92 | 1.0 | 5.97 | 12.93 | 3 | 3 | 1 |
| Comparative Composition 2 | 0.05 | - | - | Tris | 650 | 130 | - | HEDPO | 4.20 | 89.25 | 1.0 | 6.36 | 12.51 | 3 | 1 | 3 |
| Comparative Composition 3 | 0.05 | 0.38 | 7.60 | - | - | - | - | HEDPO | 4.20 | 95.37 | 1.0 | 0.96 | *1 | 3 | 1 | 3 |
| Comparative Composition 4 | 0.05 | 0.38 | 7.60 | Tris | 650 | 130 | 0.060 | - | - | 9307 | 1.0 | 9.36 | 2.83 | 1 | 3 | 3 |
| Comparative Composition 5 | 0.05 | 0.38 | 7.60 | Tris | 0.65 | 13 | 0.580 | HEDPO | 420 | 94.72 | 1.0 | 1.14 | *1 | 3 | 1 | 3 |

From the results shown in the above table, it was found that the composition according to the embodiment of the present invention had an effect that the residue removability, the anticorrosion properties, and the wiring electrical properties in a case of cleaning a semiconductor substrate using the composition after a lapse of time were balanced and excellent, as compared with the comparative compositions 1 to 4 which did not contain any of the sorbic acid, the citric acid, the component C, or the component D, and the comparative composition 5 having a pH of less than 4.0.

In a case where the content of the sorbic acid was 0.001% by mass or more with respect to the total mass of the composition, it was found that the wiring electrical properties were more excellent, and in a case where the content of the sorbic acid was 0.01% by mass or more with respect to the total mass of the composition, it was found that the residue removability and the wiring electrical properties were more excellent (comparison of compositions 107 to 109).

In addition, in a case where the component D had a phosphono group, it was found that the anticorrosion properties with respect to the W film were more excellent (comparison of compositions 107 and 113 to 116). In addition, in a case where the component D had at least two phosphono groups, it was found that the anticorrosion properties with respect to the W film were further excellent (comparison of compositions 107 and 113 to 115).

### [Example 2]

Compositions 101 to 106 and 110 to 115 were prepared according to the method described in the preparation example of Example 1. Each of the prepared compositions was diluted 100 times in terms of mass ratio with ultrapure water to prepare compositions 201 to 212.

800 mL of a sample of each composition prepared by the above-described method was transferred to a "CLEANBARRIER BOTTLE" (manufactured by AICELLO CORPORATION, capacity: 1 L) under atmospheric pressure, and the bottle was sealed while leaving a space under atmospheric pressure in an upper part of the container. The container accommodating the sample was stored in a dark place environment of 25°C for 14 days.

Using each of the samples obtained after the storage, the anticorrosion properties, the residue removability, and the wiring electrical properties were evaluated according to the test methods described in Example 1, respectively.

Table 2 shows the pH and the electrical conductivity of the compositions 201 to 212, and the evaluation results by the above-described evaluations.

The content of each component other than water, contained in the compositions 201 to 212, was 1/100 of the content of each component of the compositions 101 to 106 and 110 to 115, and the content of water was a remainder obtained by subtracting the total content of each component other than water. In addition, the ratio B/A, the ratio C/A, and the ratio B/C of the compositions 201 to 212 were the same as the ratio B/A, the ratio C/A, and the ratio B/C of the compositions 101 to 106 and 110 to 115, respectively.

**[Table 2]**

| | Composition | | Evaluation | | |
|---|---|---|---|---|---|
| | pH | Electrical conductivity (mS/cm) | Residue removability | Anticorrosion properties | Wiring electrical properties |
| Composition201 | 6.57 | 0.37 | 6 | 6 | 7 |
| Composition202 | 6.79 | 0.37 | 6 | 6 | 4 |
| Composition203 | 6.65 | 0.38 | 7 | 6 | 7 |
| Composition204 | 6.92 | 0.37 | 6 | 6 | 7 |
| Composition205 | 5.27 | 0.38 | 7 | 6 | 7 |
| Composition206 | 7.24 | 0.35 | 6 | 6 | 7 |
| Composition207 | 6.81 | 0.45 | 6 | 7 | 7 |
| Composition208 | 6.79 | 0.61 | 7 | 7 | 6 |
| Composition209 | 6.34 | 0.45 | 7 | 6 | 7 |
| Composition 10 | 6.93 | 0.63 | 6 | 6 | 7 |
| Composition211 | 7.05 | 0.87 | 6 | 5 | 7 |
| Composition212 | 6.95 | 0.58 | 6 | 4 | 7 |

From the results shown in the above table, it was found that, in the compositions 201 to 212, the residue removability, the anticorrosion properties, and the wiring electrical properties in a case of cleaning a semiconductor substrate using the composition after a lapse of time were balanced and excellent as in the compositions of 101 to 106 and 110 to 115.

## Claims

1. A composition comprising:
sorbic acid;
citric acid;
an amine-containing compound which is at least one selected from the group consisting of ammonia, an organic amine, a quaternary ammonium compound, and salts thereof;
a specific compound which has at least one group selected from the group consisting of a phosphono group and a phosphoric acid group; and
water,
wherein a pH at 25°C is 4.0 to 9.0.

2. The composition according to claim 1,
wherein a ratio of a content of the citric acid to a content of the sorbic acid is 1 to 50 in terms of mass ratio.

3. The composition according to claim 1 or 2,
wherein a ratio of a content of the amine-containing compound to a content of the sorbic acid is 10 to 500 in terms of mass ratio.

4. The composition according to any one of claims 1 to 3,
wherein the specific compound includes a compound having a phosphono group.

5. The composition according to any one of claims 1 to 4,
wherein the specific compound includes a compound having at least two phosphono groups.

6. The composition according to any one of claims 1 to 5,
wherein the amine-containing compound includes at least one selected from the group consisting of ammonia, an alkanolamine, a quaternary ammonium compound, and salts thereof.

7. The composition according to any one of claims 1 to 6,
wherein the amine-containing compound includes an alkanolamine.

8. The composition according to any one of claims 1 to 7,
wherein the composition contains substantially no abrasive grains.

9. The composition according to any one of claims 1 to 8,
wherein an electrical conductivity at 25°C is 0.01 to 30 mS/cm.

10. The composition according to any one of claims 1 to 9,
wherein a content of a phosphate ion is 20 mass ppm or less with respect to the composition.

11. The composition according to any one of claims 1 to 10,
wherein the composition is used in a cleaning liquid for a semiconductor substrate which has been subjected to a chemical mechanical polishing treatment.

12. The composition according to claim 11,
wherein the semiconductor substrate contains tungsten.

13. The composition according to claim 11 or 12,
wherein a diluted liquid obtained by diluting the composition with water by 50 times or more is used as the cleaning liquid.

14. A manufacturing method of a semiconductor element, comprising:
a step of cleaning a semiconductor substrate using the composition according to any one of claims 1 to 12.

15. A manufacturing method of a semiconductor element, comprising:
a step of subjecting a semiconductor substrate to a chemical mechanical polishing treatment; and
a step of cleaning the semiconductor substrate which has been subjected to the chemical mechanical polishing treatment using the composition according to any one of claims 1 to 12 or a diluted liquid obtained by diluting the composition with water.
